(19)

Europäisches
Patentamt
European
Patent Office
Office européen
des brevets

(11) **EP 2 947 837 A1**

(12) **EUROPEAN PATENT APPLICATION**

(43) Date of publication:
**25.11.2015 Bulletin 2015/48**

(21) Application number: **14169537.9**

(22) Date of filing: **22.05.2014**

(51) Int Cl.:
*H04L 27/34* [(2006.01)]    *H03M 13/11* [(2006.01)]
*H03M 13/25* [(2006.01)]    *H04L 1/00* [(2006.01)]
*H03M 13/27* [(2006.01)]

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Panasonic Corporation
Kadoma-shi
Osaka 571-8501 (JP)**

(72) Inventors:
• **Klenner, Peter
63225 Langen (DE)**

• **Herrmann, Frank
63225 Langen (DE)**
• **Kimura, Tomohiro
Osaka-shi, Osaka 540-6207 (JP)**

(74) Representative: **Grünecker Patent- und
Rechtsanwälte
PartG mbB
Leopoldstraße 4
80802 München (DE)**

(54) **Cyclic-block permutations for 1D-4096-QAM with quasi-cyclic LDPC codes and code rates 9/15 and 13/15**

(57) The present invention relates to digital communication systems based on quasi-cyclic low-density parity-check (QC-LDPC) codes and high-order constellations. The invention provides specific permutations for interleaving first cyclic blocks and then bits within a section of cyclic blocks of an LDPC codeword and specific non-uniform 64-PAM constellations for transmitting the interleaved codeword. The permutations and the non-uniform constellations have been jointly optimized for code rates of 9/15, and 13/15.

Fig. 2

EP 2 947 837 A1

**Description**

TECHNICAL FIELD

The present invention relates to the field of digital communications, and more specifically to bit interleavers and de-interleavers for bit-interleaved coding and modulation systems with quasi-cyclic low-density parity-check codes, and QAM modulation, as well as to corresponding methods, transmitters, and receivers.

BACKGROUND OF THE INVENTION

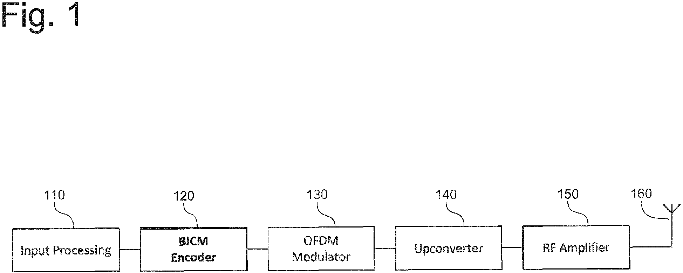

Figure 1 is a block diagram of a transmitter-side communication chain involving bit-interleaved coding and modulation (BICM). The input processing unit (110) formats the input bitstreams into blocks of a predetermined length called baseband frames. The BICM encoder (120) converts the baseband frames into a plurality of complex-valued data streams. Each stream is further processed by a chain comprising at least a modulator (130), an up-converter (140) from digital baseband to analog RF, and a radio-frequency RF power amplifier (150) for driving an antenna (160). The modulator (130) uses e.g. orthogonal frequency-division multiplexing (OFDM) modulation and typically includes time and frequency interleaving for increased diversity.

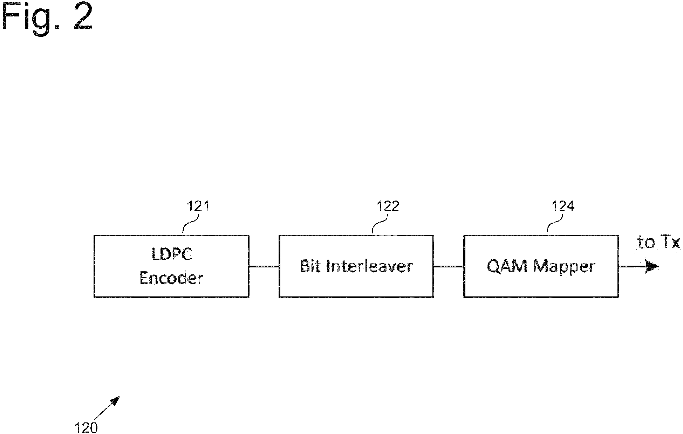

Figure 2 is the block diagram of a BICM encoder (120). The input blocks, i.e. baseband frames, are encoded by the low-density parity-check (LDPC) encoder (121) and fed to bit interleaver (122), which applies a permutation to the bits of each LDPC codeword before mapping them to complex cells by a constellation mapper (124), which employs quadrature amplitude modulation (QAM).

The components of the BICM encoder in Figure 2 will now be explained in more detail.

The LDPC encoder (121) encodes baseband frames according to a specified LDPC code. The present invention is specifically designed for LDPC block codes with staircase parity structure, as encountered in the DVB-S2, DVB-T2 and DVB-C2 standards, and variants as Raptor-like LDPC cpdes. More details will be given below.

An LDPC block code is a linear error-correcting code that is fully defined by its parity-check matrix (PCM), which is a binary sparse matrix that represents the connection of the codeword bits (also referred to as bit nodes or variable nodes) to the parity checks (also referred to as check nodes CN). The columns and the rows of the PCM correspond to the variable nodes and the check nodes, respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more folded diagonals.

The size of each circulant is QxQ, where Q is called the cyclic factor of the LDPC code. Such a quasi-cyclic structure allows Q check nodes to be processed in parallel, which is clearly advantageous for an efficient hardware implementation. The PCM of a quasi-cyclic LDPC code has therefore QM rows and QN columns, a codeword consisting of N blocks of Q bits. A Q-bit block is referred to as a quasi-cyclic block or simply cyclic block throughout this document and is abbreviated as QB.

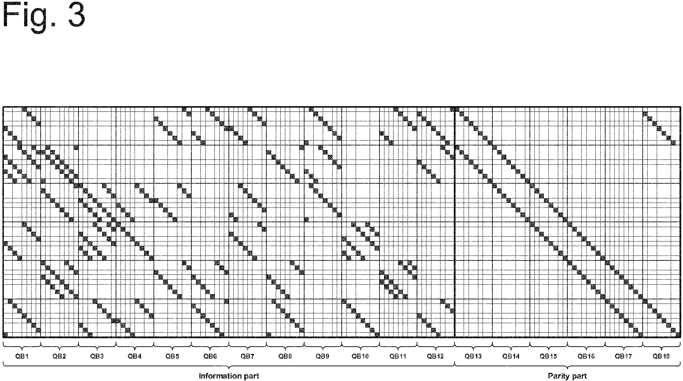

Figure 3 shows the PCM of an example LDPC code with M=6, N=18, and Q=8, the PCM having circulants with one or two diagonals. This code encodes a block of 8x12=96 bits to a codeword of 8x18=144 bits, having therefore a code rate of 2/3.

The code whose PCM is shown in Figure 3 belongs to a special family of QC LDPC codes called repeat-accumulate (RA) QC LDPC codes. These codes are well known for their ease of encoding and are encountered in a large number of standards, such as the second-generation DVB standards: DVB-S2, DVB-T2 and DVB-C2.

In the following, the definition of the repeat-accumulate quasi-cyclic LDPC codes used in the DVB-S2, DVB-T2 and DVB-C2 family of standards, as introduced in Section 5.3.2 and Annexes B and C of the DVB-S2 standard ETSI EN 302 307, V1.2.1 (August 2009), will be discussed. In this family of standards the cyclic factor Q is 360.

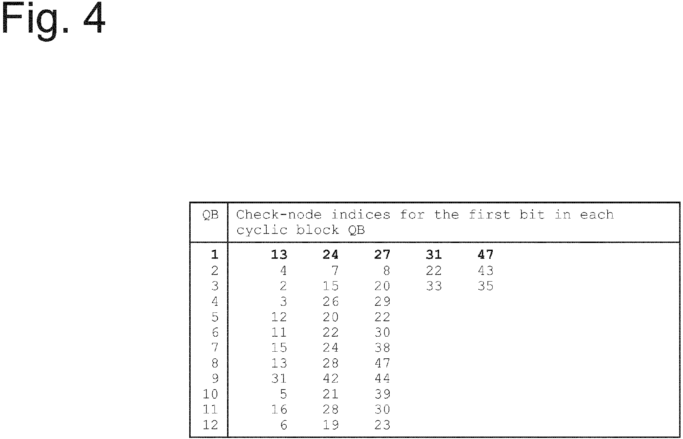

Each LDPC code is fully defined by a table that contains, for the first bit of each cyclic block in the information part, the zero-based indices of the check nodes the bit is connected to. These indices are referred to as "addresses of the parity bit accumulators" in the DVB-S2 standard. For the example LDPC code of Figure 3 this table is shown in Fig. 4.

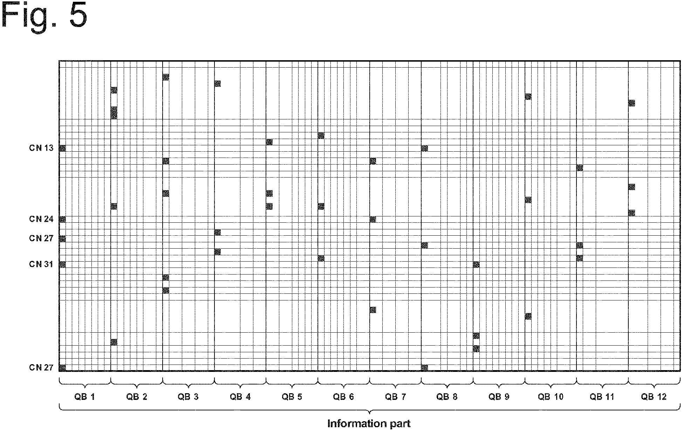

Figure 5 shows the information part of the parity-check matrix for the first bit in each cyclic block of the information part.

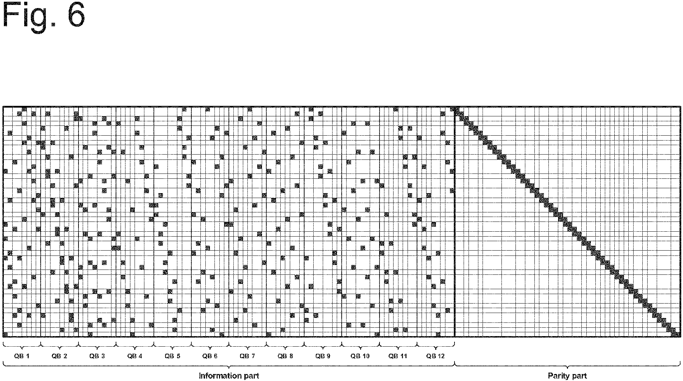

The full parity-check matrix, containing the entries for all information bits, as well as the staircase parity part, is shown in Figure 6.

For the other information bits, the CN indices are computed with the following formula:

$$i_q = (i_0 + q*M)\%(Q*M),$$

where q is the bit index (0...Q-1) within a cyclic block; iq is the CN index for bit q; $i_0$ is one of the CN indices in Table 1; M is the number of cyclic blocks in the parity part, i.e. 6 in this example; Q*M is the number of parity bits, i.e. 48 in this example; and % denotes the modulo operator.

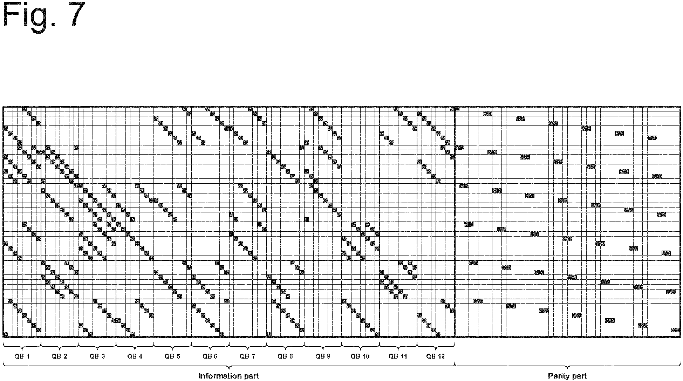

In order to reveal the quasi-cyclic structure of the parity-check matrix in Figure 6, the following permutation is applied to the rows of the matrix, the resulting matrix being shown in Figure 7:

$$j = (i\%M)*Q + floor(i/M)$$

where i and j are the zero-based indices of the non-permuted and the permuted CNs, respectively, and % denotes the modulo operator.

Since the permutation is not applied to the bits, the code definition does not change. The parity part of the resulting parity-check matrix is not quasi cyclic, however. In order to make it quasi cyclic, a special permutation must be applied to the parity bits only:

$$j = [i\%Q]*M + floor(i/Q)$$

where i and j are the zero-based indices of the non-permuted and permuted parity bits respectively.

This permutation changes the code definition and will be referred to as parity permutation or parity interleaving throughout this document. Moreover, this permutation will be regarded as part of the LDPC encoding process from now on.

The upcoming ATSC 3.0 standard for terrestrial reception of digital video services is currently under development and will define the following code rates: 1/15, 2/15,...,13/15 as well as codeword lengths 16200 and 64800 codebits.

QAM mapping

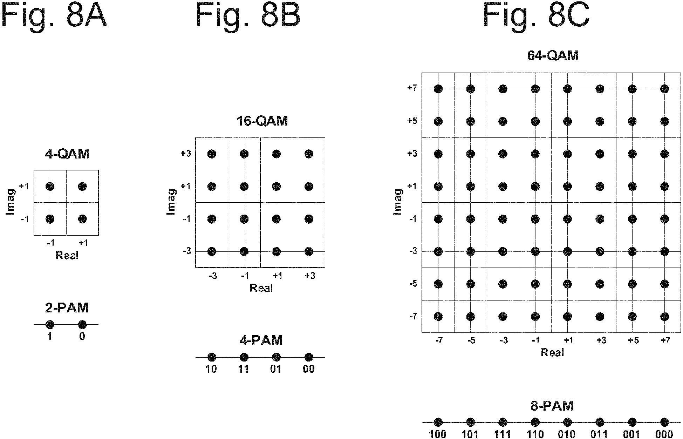

A QAM constellation is obtained by independently modulating the real and the imaginary components using pulse-amplitude modulation (PAM), each point in the constellation corresponding to a unique combination of bits. Figures 8A-8C show the three types of QAM constellations relevant to the present invention: 4-QAM, 16-QAM, and 64-QAM, where the real and imaginary components have the same PAM modulation: 2-PAM, 4-PAM, and 8-PAM, respectively. The present invention also assumes that the PAM mapping has a Gray encoding, as shown in Figures 8A-8C.

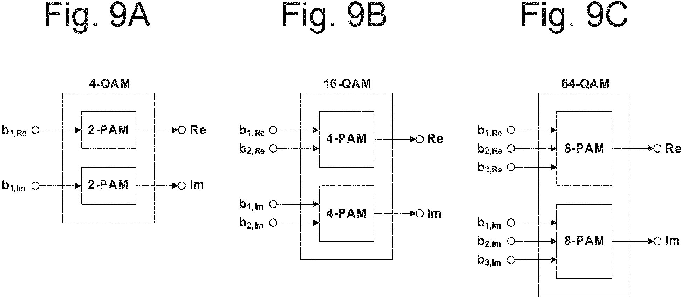

Figures 9A-9C show the corresponding QAM mappers for the three constellations. Each QAM mapper consists of two independent PAM mappers, each encoding the same number of bits.

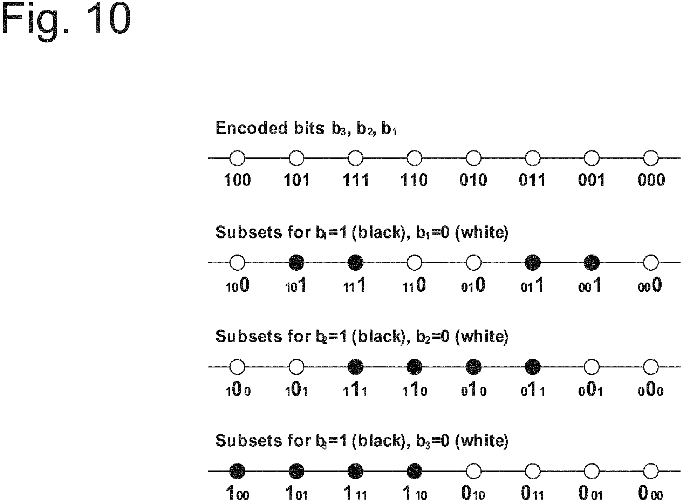

The bits encoded in a PAM symbol have different robustness levels (reliabilities) when the received PAM symbol is demapped in the receiver. This is a well known fact and is illustrated in Figure 10 for an 8-PAM symbol with Gray encoding. The different robustness levels result from the fact that the distance between the two partitions defined by a bit (0 or 1) is different for each of the three bits. The reliability of a bit is proportional to the average distance between the two partitions defined by that bit. In the example shown in Figure 10, bits b1, b2, b3 have increasing reliabilities.

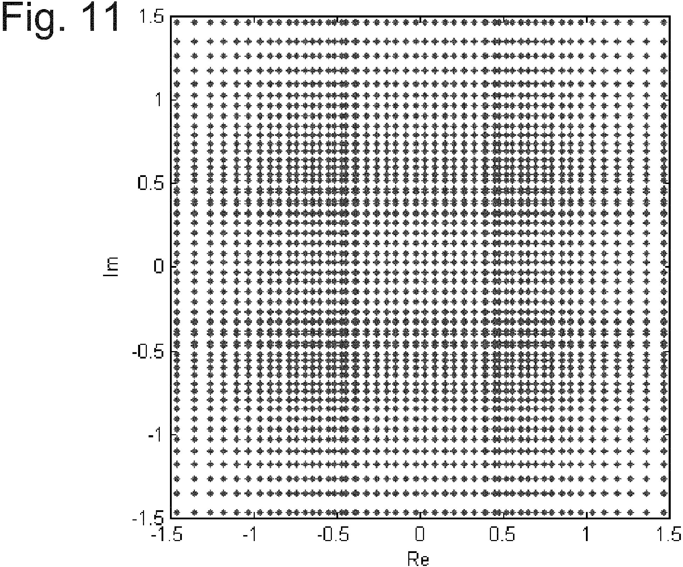

To increase the rate at which bits are transmitted, i.e., the BICM capacity, non-uniform constellations have been introduced in DVB-NGH for the first time. This increase is achieved by varying the spacing between the PAM constellation points, resulting in so called 1D-NU-PAMs, which in turn result in rectangular non-uniform constellation. In ATSC 3.0, this idea is further improved by introducing 2D non-uniform constellations, so called 2D-NUCs. The latter entail increased demapping complexity at the receiver since I- and Q-components of the received cells are now dependent. Higher demapping complexity is deemed acceptable within ATSC 3.0 up to a constellation order of 1024. Beyond that it was decided to allow only PAM based constellations for 4096 QAM constellations. An example constellation for a 4096-QAM based on 1 D-64 NU-PAM is depicted in Figure 11.

The number of bits in a QAM symbol is denoted by B. Since the QAM constellations are square, B is even. Moreover, since a square QAM symbol consists of two identical PAM symbols, the bits encoded in a QAM symbol can be grouped in pairs having the same robustness. In the following, the bits encoded in a QAM constellation will be referred to as a constellation word.

Bit interleaver

Typically, the bits of an LDPC codeword have different importance levels, and the bits of a constellation have different robustness levels. A direct, i.e. non-interleaved, mapping of the LDPC codeword bits to the QAM constellation bits leads to a suboptimal performance. In order to avoid such performance degradation the codeword bits need to be interleaved prior to being mapped onto constellations. For this purpose, a bit interleaver 122 is used between the LDPC encoder 121 and the QAM constellation mapper 124, as illustrated in Figure 2. By carefully designing the interleaver, an optimum association can be achieved between the bits of the LDPC codeword and the bits encoded by the constellation, leading to an improved performance. A typical measure of the performance is the bit-error rate (BER) or the frame-error rate (FER) as a function of the signal-to-noise ratio (SNR).

The different importance levels of the bits of an LDPC codeword result primarily from the fact that not all the bits are involved in the same number of parity checks. The more parity checks (check nodes) a codeword bit (variable node) is involved in, the more important that bit is in the iterative LDPC decoding process. A further reason is the fact that the variable nodes have different connectivities to the cycles in the Tanner graph representation of the LDPC code, so they may still have different importance levels even when they are involved in the same number of parity checks. These aspects are well understood in the art. As a general rule, the importance level of a variable node increases with the number of check nodes it is connected to.

In the particular case of quasi-cyclic LDPC codes, all bits in a cyclic block of Q bits have the same importance since all of them are involved in the same number of parity checks and have the same connectivity to the cycles in the Tanner graph.

In the following, a method for mapping the bits of a quasi-cyclic LDPC codeword to constellation words is described. This mapping is performed by bit interleaver 122 in Figure 2. The method is introduced in co-pending application EP 11 006 087.8, which is incorporated herewith in its entirety, for a generic number T of transmit antennas and will be explained in the following for the case relevant to the present invention, i.e. for T=1 transmit antennas. The present invention is specifically optimized for and works in conjunction with such a mapping.

According to co-pending application EP 11 006 087.8, the bits of a quasi-cyclic LDPC codeword are mapped to constellation words such that (i) each constellation word is made up of bits from B/2 different cyclic blocks of the codeword, and (ii) each pair of constellation word bits that are encoded in the same QAM symbol and have the same robustness is made up of bits from the same cyclic block.

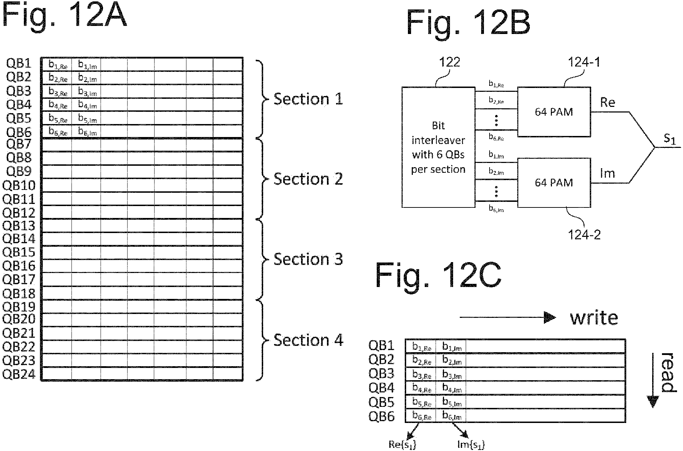

Specifically, the Q·B/2 bits of the B/2 cyclic blocks are mapped to Q/2 spatial-multiplexing blocks. In this case, the B/2 cyclic blocks are referred to as a section. Such a configuration is illustrated in Figs. 12A with four sections and 24 cyclic blocks.

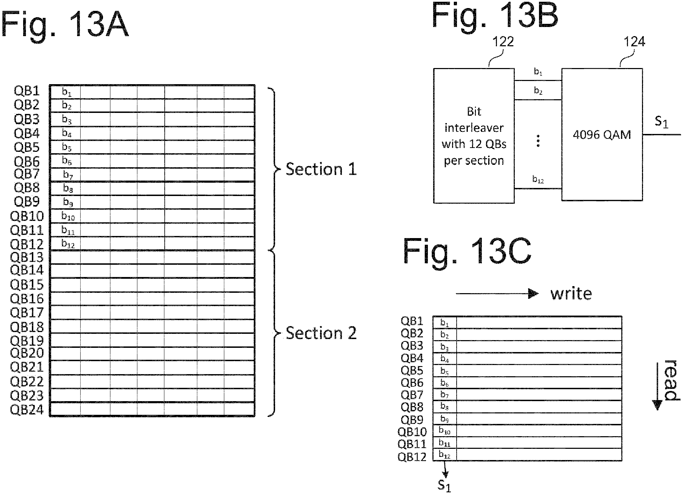

Figure 12B shows a specific configuration of the bit interleaver and the QAM mapper pathway of the BICM encoder of Fig. 2 according to DVB-NGH. Specifically, the LDPC codeword generated by LDPC encoder 121 in Fig. 2 is fed to bit interleaver 122 in Fig. 13. The bits of the permuted codeword are then allocated to the real and the imaginary parts of the corresponding constellation words. These bits ($b_{1,Re}$, $b_{1,lm}$, ...) are then mapped to a complex symbol (Re, lm) by means of a pair of PAM mappers (124-1, 124-2).

Figure 12C shows a representation of the reordering performed by the bit interleaver 122. As it is illustrated in Fig. 12C, all bits of the codeword are written row-by-row into a matrix, from where they are read in a column-by-column fashion.

Figures 13A to 13C illustrate another specific configuration of the bit interleaver and the QAM mapper pathway of the BICM encoder of Fig. 2. Figs. 13A to 13C are similar to Figs. 12A to 12C, respectively, except that these figures illustrate the configuration of the bit interleaver and the QAM mapper pathway of the BICM encoder according to ATSC 3.0.

SUMMARY OF THE INVENTION

It is an object of the present invention to improve the performance of communication systems that employ quasi-cyclic LDPC codes and high order constellations.

This is achieved by the features as set forth in the independent claims.

Preferred embodiments are the subject matter of dependent claims.

It is the particular approach of the present invention to select a specifically optimized quasi-cyclic block permutation and/or a specifically optimized non-uniform constellation on the basis of the code rate of the quasi-cyclic LDPC code that is employed for communicating data in a digital communication system.

According to a first aspect of the present invention, a method for communicating data in a digital communication system employing a quasi-cyclic low-density parity-check code is provided. The method comprises an interleaving step for applying a cyclic block permutation to a codeword of the quasi-cyclic low-density parity-check code, the codeword consisting of a sequence of N cyclic blocks, each cyclic block consisting of Q bits, N and Q being positive integers, the cyclic block permutation being configured for permuting the sequence of cyclic blocks within the codeword; and a constellation mapping or de-mapping step for mapping bits of the permuted codeword to constellation points of a non-uniform constellation, or vice versa, the non-uniform constellation and the cyclic-block permutation being selected on the basis of a code rate of the employed quasi-cyclic low-density parity-check code.

In a preferred embodiment, the quasi-cyclic low-density parity-check code has a code rate of 9/15 and the selected non-uniform constellation is a non-uniform 4096-QAM constellation having real and complex coordinates given by non-uniform 64-PAM according to Table 1 and/or the selected non-uniform constellation is a non-uniform 4096-QAM constellation having real and complex coordinates given by non-uniform 64-PAM according to Table 2.

In another preferred embodiment, the quasi-cyclic low-density parity-check code has a code rate of 13/15 and the selected non-uniform constellation is a non-uniform 4096-QAM constellation having real and complex coordinates given by non-uniform 64-PAM according to Table 3 and/or the selected non-uniform constellation is a non-uniform 4096-QAM constellation having real and complex coordinates given by non-uniform 64-PAM according to Table 4.

In another preferred embodiment, the quasi-cyclic low-density parity-check code has a code rate of 9/15 and the selected non-uniform constellation is a non-uniform 4096-QAM constellation having real and complex coordinates given by non-uniform 64-PAM according to Table 5 and/or the selected non-uniform constellation is a non-uniform 4096-QAM constellation having real and complex coordinates given by non-uniform 64-PAM according to Table 6.

In another preferred embodiment, the quasi-cyclic low-density parity-check code has a code rate of 13/15 and the selected non-uniform constellation is a non-uniform 4096-QAM constellation having real and complex coordinates given by non-uniform 64-PAM according to Table 7 and/or the selected non-uniform constellation is a non-uniform 4096-QAM constellation having real and complex coordinates given by non-uniform 64-PAM according to Table 8.

In a preferred embodiment, the number of cyclic blocks equals 180 and the number of bits per cyclic block equals 360.

In a preferred embodiment, the method further comprises the step of selecting the employed quasi-cyclic low-density parity-check code from a plurality of predefined quasi-cyclic low-density parity-check codes, each of the predefined quasi-cyclic low-density parity-check codes having a distinct code rate.

According to a second aspect of the present invention, a transmitter of a digital communication system is provided, which is adapted for transmitting data by performing all steps of a method according to the first aspect.

According to a third aspect of the present invention, a receiver of a digital communication system is provided, which is adapted for receiving data by performing all steps of a method according to the first aspect.

The above and other objects and features of the present invention will become more apparent from the following description and preferred embodiments given in conjunction with the accompanying drawings, in which:

Fig. 1            is a block diagram of a transmitter-side communication chain involving bit-interleaved coding and modulation;

Fig. 2            is a block diagram of a bit-interleaved coding and modulation encoder;

Fig. 3            shows the parity check matrix of an exemplary LDPC code with cyclic factor Q=8;

Fig. 4            is a table with an examplary repeat-accumulate LDPC code definition;

Fig. 5            shows the information part of the parity-check matrix for the LDPC code of Fig. 4 for the first bit in each cyclic block of the information part;

Fig. 6            shows the full parity-check matrix of Fig. 5, containing the entries for all information bits, as well as the staircase parity part;

Fig. 7            shows the quasi-cyclic structure of the parity-check matrix of Fig. 6;

Figs. 8A to 8C    illustrate a 4-QAM constellation, a 16-QAM constellation, and a 64-QAM constellation, respectively;

Figs. 9A to 9C    show a block diagram of a 4-QAM (QPSK) constellation mapper, a 16-QAM constellation mapper, and a 64-QAM constellation mapper, respectively;

Fig. 10           is a schematic illustration of the different robustness levels in a 8-PAM symbol with Gray encoding;

Fig. 11           is a schematic illustration of an example constellation for 4096-QAM based on 1 D-64 NU-PAM designed for a specific SNR;

Fig. 12A to 12C   are schematic representations of specific configurations of the bit-interleaving coding and modulation encoder of Fig. 2 according to DVB-NGH.

Figs. 13A to 13C    are schematic representations of specific configurations of the bit-interleaving coding and modulation encoder of Fig. 2 according to ATSC 3.0.

Figs. 14    shows a structural representation of a bit interleaver according to an embodiment of the present invention;

DETAILED DESCRIPTION

The present invention provides a bit interleaver that ensures that the B bits of each QAM symbol are mapped to exactly B/2 cyclic blocks of the quasi-cyclic LDPC codeword in such a way that each of the B/2 cyclic blocks is associated with bits of the same robustness. In other words, each constellation word is made up of bits from B/2 different cyclic blocks of the codeword and each pair of constellation word bits that have the same robustness is made up of bits from the same cyclic block.

As already mentioned above, different cyclic blocks of a given LDPC code may have different importance levels, depending on the number of check nodes to which they are connected. Therefore, transmission performance may be improved by matching the importance of the cyclic blocks and the robustness of the constellation word bits to which they are mapped. Specifically, the bits of cyclic blocks having the highest importance are mapped to constellation word bits having the highest robustness. Conversely, bits of cyclic blocks having the lowest importance are mapped to constellation word bits having the lowest robustness.

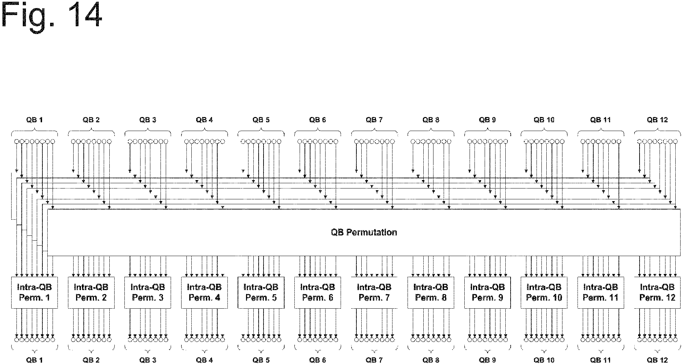

Fig. 14 shows a structural representation of a bit interleaver according to an embodiment of the present invention. In the example shown, an LDPC codeword consists of N=12 cyclic blocks QB1, ..., QB12 with Q=8 bits each.

The bit interleaving process may comprise two stages. In a first stage, a cyclic block permutation (QB permutation) is applied to the codeword in order to rearrange the sequence of the cyclic blocks, without affecting the sequence of the bits within each cyclic block. In a second stage, the bits of the shuffled cyclic blocks are mapped to the constellation words. The latter step can be implemented by dividing the codeword into a plurality of sections and performing the mapping to the constellation words on a section-by-section basis ("section permutation"). Each section is preferably made up of B/2 cyclic blocks such that the above conditions can be met.

The inventor has realized that the performance of the communication system can be improved for a given LDPC code by optimizing the cyclic block permutation, i.e., by choosing a cyclic block permutation that matches constellation bits of different reliabilities with cyclic blocks of different importance levels.

The mapping of cyclic blocks to constellation word bits, however, is not straightforward. Finding optimized cyclic block permutations is a very time-consuming process as no analytical solutions are known so far. The method used for finding the optimized cyclic block permutations disclosed in the present invention consists of the following steps, which are applied for each of the different constellations and code rates.

In a preliminary step, a huge number (1 e4...1 e5) of unconstrained random QB permutations are generated. For these permutations, Monte-Carlo simulations are performed with blind and iterative demapping in order to determine the threshold SNR (signal-to-noise ratio) at a given target BLER (block error rate). The permutation that has the lowest threshold SNR, i.e. the best performance, is kept.

The inventor discovered that optimizing the QB permutation for blind demapping results in suboptimal performance with iterative demapping and vice versa. Finding permutations that are good for both types of demapping remains a challenging task.

It is therefore an object of the present invention to present QB permutations that have good performance with both blind and iterative demapping.

From the preliminary step, the SNR range for various QB permutations can be determined. Then, a threshold SNR is set in order to select only permutations that have good performance with blind demapping. Good performance means low SNR. The threshold should not be set too low since that will exclude many permutations that are very good with iterative demapping. Besides, permutations that are heavily optimized for blind demapping perform badly with iterative demapping. Selecting the initial threshold SNR appropriately is a question of experience.

In a first selection step, a large number of unconstrained random QB permutations is generated. For each permutation, the corresponding BLER curve is determined, e.g. through Monte-Carlo simulations, and only the permutations with a SNR at the target BLER lower than the defined threshold SNR are kept. For the surviving permutations, the BLER curves with iterative demapping are determined and the best permutation is kept.

In a second selection step, a medium number of constrained random permutations derived from the permutation returned by the first selection step is generated, and the selection criterion from the first selection step is applied. The constrained permutations are derived by applying a random permutation to the cyclic blocks of a single randomly selected section. Applying such a constraint ensures that the variations in performance are small and concentrated around the already good permutation selected in the first step. In this manner, better permutations can be found more efficiently than by using a blind unconstrained search.

In a third selection step, a medium number of constrained random permutations is derived from the permutation returned by the second selection step and the selection criterion from the first selection step is applied. The constrained permutations are derived by applying random permutations to bits having the same robustness level. Therefore, variations in performance are rather small and affect the iterative demapping more than the blind demapping. The performance with iterative demapping can therefore be optimized without sacrificing the performance with blind demapping.

Optimizations have been performed for code rates of 9/15 and 13/15. Simultaneous to optimizing the permutations, the optimum non-uniform constellations to be used in conjunction with code rates of 9/15 and 13/15 have been determined as well. Results of the optimization are disclosed herebelow.

Tables 1 and 2 disclose the optimized cyclic block permutation and the non-uniform QAM constellation according to the present invention for a code rate of 9/15.

**Table 1: QB permutation for code rate 9/15 and PAM constellation A9**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 143 | 45 | 80 | 90 | 163 | 135 | 16 |
| 1 | 34 | 46 | 39 | 91 | 109 | 136 | 41 |
| 2 | 146 | 47 | 82 | 92 | 158 | 137 | 176 |
| 3 | 131 | 48 | 21 | 93 | 6 | 138 | 141 |
| 4 | 47 | 49 | 0 | 94 | 175 | 139 | 89 |
| 5 | 70 | 50 | 66 | 95 | 73 | 140 | 139 |
| 6 | 48 | 51 | 67 | 96 | 4 | 141 | 111 |
| 7 | 75 | 52 | 38 | 97 | 11 | 142 | 127 |
| 8 | 114 | 53 | 60 | 98 | 27 | 143 | 155 |
| 9 | 103 | 54 | 2 | 99 | 62 | 144 | 117 |
| 10 | 164 | 55 | 125 | 100 | 33 | 145 | 74 |
| 11 | 168 | 56 | 144 | 101 | 157 | 146 | 9 |
| 12 | 40 | 57 | 55 | 102 | 161 | 147 | 84 |
| 13 | 100 | 58 | 86 | 103 | 58 | 148 | 50 |
| 14 | 149 | 59 | 126 | 104 | 45 | 149 | 162 |
| 15 | 128 | 60 | 99 | 105 | 43 | 150 | 87 |
| 16 | 151 | 61 | 63 | 106 | 140 | 151 | 133 |
| 17 | 76 | 62 | 178 | 107 | 110 | 152 | 36 |
| 18 | 115 | 63 | 26 | 108 | 24 | 153 | 96 |
| 19 | 77 | 64 | 17 | 109 | 145 | 154 | 12 |
| 20 | 5 | 65 | 83 | 110 | 118 | 155 | 31 |
| 21 | 90 | 66 | 97 | 111 | 122 | 156 | 57 |
| 22 | 105 | 67 | 167 | 112 | 1 | 157 | 92 |
| 23 | 171 | 68 | 142 | 113 | 120 | 158 | 147 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 172 | 69 | 121 | 114 | 134 | 159 | 104 |
| 25 | 71 | 70 | 165 | 115 | 108 | 160 | 42 |
| 26 | 53 | 71 | 95 | 116 | 14 | 161 | 78 |
| 27 | 160 | 72 | 170 | 117 | 61 | 162 | 154 |
| 28 | 106 | 73 | 173 | 118 | 112 | 163 | 7 |
| 29 | 30 | 74 | 22 | 119 | 153 | 164 | 101 |
| 30 | 8 | 75 | 159 | 120 | 10 | 165 | 129 |
| 31 | 56 | 76 | 3 | 121 | 148 | 166 | 135 |
| 32 | 136 | 77 | 137 | 122 | 124 | 167 | 138 |
| 33 | 166 | 78 | 52 | 123 | 88 | 168 | 46 |
| 34 | 81 | 79 | 116 | 124 | 98 | 169 | 44 |
| 35 | 20 | 80 | 152 | 125 | 179 | 170 | 54 |
| 36 | 23 | 81 | 49 | 126 | 18 | 171 | 35 |
| 37 | 32 | 82 | 72 | 127 | 37 | 172 | 102 |
| 38 | 174 | 83 | 107 | 128 | 169 | 173 | 68 |
| 39 | 123 | 84 | 65 | 129 | 29 | 174 | 91 |
| 40 | 25 | 85 | 51 | 130 | 13 | 175 | 19 |
| 41 | 94 | 86 | 93 | 131 | 113 | 176 | 177 |
| 42 | 156 | 87 | 15 | 132 | 132 | 177 | 28 |
| 43 | 59 | 88 | 79 | 133 | 85 | 178 | 150 |
| 44 | 130 | 89 | 64 | 134 | 69 | 179 | 119 |

**Table 2: PAM constellation A9 for code rate 9/15**

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,6273 | 16 | 0,0573 | 32 | -1,6273 | 48 | -0,0573 |
| 1 | 1,4346 | 17 | 0,0574 | 33 | -1,4346 | 49 | -0,0574 |
| 2 | 1,1703 | 18 | 0,0574 | 34 | -1,1703 | 50 | -0,0574 |
| 3 | 1,283 | 19 | 0,0575 | 35 | -1,283 | 51 | -0,0575 |
| 4 | 0,8854 | 20 | 0,1728 | 36 | -0,8854 | 52 | -0,1728 |
| 5 | 0,8979 | 21 | 0,1726 | 37 | -0,8979 | 53 | -0,1726 |
| 6 | 1,0517 | 22 | 0,1724 | 38 | -1,0517 | 54 | -0,1724 |
| 7 | 1,0063 | 23 | 0,1722 | 39 | -1,0063 | 55 | -0,1722 |
| 8 | 0,5401 | 24 | 0,4247 | 40 | -0,5401 | 56 | -0,4247 |
| 9 | 0,5402 | 25 | 0,4244 | 41 | -0,5402 | 57 | -0,4244 |
| 10 | 0,5772 | 26 | 0,4122 | 42 | -0,5772 | 58 | -0,4122 |
| 11 | 0,5777 | 27 | 0,4118 | 43 | -0,5777 | 59 | -0,4118 |
| 12 | 0,7733 | 28 | 0,2904 | 44 | -0,7733 | 60 | -0,2904 |
| 13 | 0,7706 | 29 | 0,2905 | 45 | -0,7706 | 61 | -0,2905 |
| 14 | 0,6908 | 30 | 0,2937 | 46 | -0,6908 | 62 | -0,2937 |
| 15 | 0,6902 | 31 | 0,2935 | 47 | -0,6902 | 63 | -0,2935 |

Tables 3 and 4 disclose the optimized cyclic block permutation and the non-uniform QAM constellation according to the present invention for a code rate of 13/15.

**Table 3: QB permutation for code rate 13/15 and Pam constellation A13**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 97 | 45 | 142 | 90 | 67 | 135 | 141 |
| 1 | 133 | 46 | 34 | 91 | 131 | 136 | 173 |
| 2 | 55 | 47 | 124 | 92 | 53 | 137 | 26 |
| 3 | 104 | 48 | 90 | 93 | 121 | 138 | 145 |
| 4 | 56 | 49 | 49 | 94 | 162 | 139 | 155 |
| 5 | 21 | 50 | 77 | 95 | 58 | 140 | 93 |
| 6 | 36 | 51 | 157 | 96 | 89 | 141 | 100 |
| 7 | 126 | 52 | 127 | 97 | 27 | 142 | 113 |
| 8 | 122 | 53 | 123 | 98 | 118 | 143 | 40 |
| 9 | 132 | 54 | 11 | 99 | 83 | 144 | 65 |
| 10 | 68 | 55 | 61 | 100 | 153 | 145 | 99 |
| 11 | 0 | 56 | 115 | 101 | 12 | 146 | 31 |
| 12 | 96 | 57 | 24 | 102 | 152 | 147 | 63 |
| 13 | 60 | 58 | 3 | 103 | 23 | 148 | 80 |
| 14 | 71 | 59 | 166 | 104 | 109 | 149 | 176 |
| 15 | 119 | 60 | 111 | 105 | 79 | 150 | 129 |
| 16 | 85 | 61 | 170 | 106 | 14 | 151 | 64 |
| 17 | 147 | 62 | 112 | 107 | 161 | 152 | 76 |
| 18 | 50 | 63 | 44 | 108 | 19 | 153 | 8 |
| 19 | 150 | 64 | 134 | 109 | 47 | 154 | 57 |
| 20 | 140 | 65 | 38 | 110 | 130 | 155 | 75 |
| 21 | 171 | 66 | 6 | 111 | 87 | 156 | 156 |
| 22 | 116 | 67 | 20 | 112 | 106 | 157 | 28 |
| 23 | 174 | 68 | 17 | 113 | 105 | 158 | 32 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 33 | 69 | 149 | 114 | 172 | 159 | 41 |
| 25 | 165 | 70 | 151 | 115 | 81 | 160 | 92 |
| 26 | 98 | 71 | 37 | 116 | 179 | 161 | 69 |
| 27 | 52 | 72 | 43 | 117 | 35 | 162 | 103 |
| 28 | 16 | 73 | 9 | 118 | 128 | 163 | 72 |
| 29 | 102 | 74 | 169 | 119 | 108 | 164 | 22 |
| 30 | 10 | 75 | 110 | 120 | 7 | 165 | 138 |
| 31 | 2 | 76 | 137 | 121 | 4 | 166 | 148 |
| 32 | 159 | 77 | 114 | 122 | 146 | 167 | 160 |
| 33 | 154 | 78 | 74 | 123 | 168 | 168 | 120 |
| 34 | 101 | 79 | 45 | 124 | 13 | 169 | 136 |
| 35 | 59 | 80 | 143 | 125 | 62 | 170 | 125 |
| 36 | 46 | 81 | 86 | 126 | 94 | 171 | 39 |
| 37 | 5 | 82 | 82 | 127 | 88 | 172 | 135 |
| 38 | 139 | 83 | 42 | 128 | 1 | 173 | 48 |
| 39 | 18 | 84 | 66 | 129 | 177 | 174 | 73 |
| 40 | 117 | 85 | 178 | 130 | 175 | 175 | 158 |
| 41 | 107 | 86 | 78 | 131 | 15 | 176 | 70 |
| 42 | 54 | 87 | 25 | 132 | 91 | 177 | 167 |
| 43 | 30 | 88 | 144 | 133 | 51 | 178 | 164 |
| 44 | 95 | 89 | 163 | 134 | 84 | 179 | 29 |

**Table 4: PAM constellation A13 for code rate 13/15**

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,3691 | 16 | 0,0166 | 32 | -1,3691 | 48 | -0,0166 |
| 1 | 1,2875 | 17 | 0,0487 | 33 | -1,2875 | 49 | -0,0487 |
| 2 | 1,1481 | 18 | 0,114 | 34 | -1,1481 | 50 | -0,114 |
| 3 | 1,2149 | 19 | 0,0819 | 35 | -1,2149 | 51 | -0,0819 |
| 4 | 0,9184 | 20 | 0,2462 | 36 | -0,9184 | 52 | -0,2462 |
| 5 | 0,9713 | 21 | 0,2133 | 37 | -0,9713 | 53 | -0,2133 |
| 6 | 1,0859 | 22 | 0,1473 | 38 | -1,0859 | 54 | -0,1473 |
| 7 | 1,0273 | 23 | 0,1796 | 39 | -1,0273 | 55 | -0,1796 |
| 8 | 0,5657 | 24 | 0,5275 | 40 | -0,5657 | 56 | -0,5275 |
| 9 | 0,6047 | 25 | 0,4904 | 41 | -0,6047 | 57 | -0,4904 |
| 10 | 0,6861 | 26 | 0,4183 | 42 | -0,6861 | 58 | -0,4183 |
| 11 | 0,6449 | 27 | 0,4537 | 43 | -0,6449 | 59 | -0,4537 |
| 12 | 0,8677 | 28 | 0,2803 | 44 | -0,8677 | 60 | -0,2803 |
| 13 | 0,8194 | 29 | 0,3138 | 45 | -0,8194 | 61 | -0,3138 |
| 14 | 0,7288 | 30 | 0,3829 | 46 | -0,7288 | 62 | -0,3829 |
| 15 | 0,7731 | 31 | 0,3484 | 47 | -0,7731 | 63 | -0,3484 |

Tables 5 and 6 disclose the optimized cyclic block permutation and an alternative non-uniform QAM constellation according to the present invention for a code rate of 9/15.

**Table 5: QB permutation for code rate 9/15 and Pam constellation B9**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 48 | 45 | 7 | 90 | 89 | 135 | 96 |
| 1 | 161 | 46 | 115 | 91 | 1 | 136 | 55 |
| 2 | 149 | 47 | 26 | 92 | 164 | 137 | 142 |
| 3 | 59 | 48 | 51 | 93 | 70 | 138 | 86 |
| 4 | 146 | 49 | 118 | 94 | 144 | 139 | 117 |
| 5 | 121 | 50 | 171 | 95 | 83 | 140 | 131 |
| 6 | 52 | 51 | 64 | 96 | 5 | 141 | 17 |
| 7 | 123 | 52 | 4 | 97 | 135 | 142 | 61 |
| 8 | 157 | 53 | 105 | 98 | 169 | 143 | 97 |
| 9 | 23 | 54 | 108 | 99 | 20 | 144 | 178 |
| 10 | 91 | 55 | 143 | 100 | 28 | 145 | 45 |
| 11 | 175 | 56 | 94 | 101 | 139 | 146 | 66 |
| 12 | 67 | 57 | 174 | 102 | 173 | 147 | 40 |
| 13 | 58 | 58 | 134 | 103 | 47 | 148 | 75 |
| 14 | 93 | 59 | 14 | 104 | 154 | 149 | 80 |
| 15 | 85 | 60 | 42 | 105 | 38 | 150 | 155 |
| 16 | 133 | 61 | 152 | 106 | 39 | 151 | 72 |
| 17 | 11 | 62 | 50 | 107 | 79 | 152 | 119 |
| 18 | 127 | 63 | 101 | 108 | 49 | 153 | 107 |
| 19 | 44 | 64 | 35 | 109 | 84 | 154 | 82 |
| 20 | 112 | 65 | 65 | 110 | 141 | 155 | 148 |
| 21 | 114 | 66 | 126 | 111 | 120 | 156 | 25 |
| 22 | 74 | 67 | 9 | 112 | 160 | 157 | 128 |
| 23 | 12 | 68 | 125 | 113 | 116 | 158 | 137 |

EP 2 947 837 A1

(continued)

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 150 | 69 | 132 | 114 | 16 | 159 | 62 |
| 25 | 159 | 70 | 162 | 115 | 32 | 160 | 110 |
| 26 | 30 | 71 | 109 | 116 | 56 | 161 | 145 |
| 27 | 122 | 72 | 2 | 117 | 27 | 162 | 0 |
| 28 | 81 | 73 | 98 | 118 | 60 | 163 | 73 |
| 29 | 151 | 74 | 18 | 119 | 53 | 164 | 78 |
| 30 | 172 | 75 | 136 | 120 | 43 | 165 | 179 |
| 31 | 99 | 76 | 158 | 121 | 156 | 166 | 106 |
| 32 | 22 | 77 | 104 | 122 | 63 | 167 | 68 |
| 33 | 33 | 78 | 163 | 123 | 8 | 168 | 92 |
| 34 | 129 | 79 | 124 | 124 | 36 | 169 | 19 |
| 35 | 15 | 80 | 41 | 125 | 6 | 170 | 46 |
| 36 | 29 | 81 | 13 | 126 | 24 | 171 | 166 |
| 37 | 3 | 82 | 54 | 127 | 88 | 172 | 57 |
| 38 | 103 | 83 | 176 | 128 | 113 | 173 | 37 |
| 39 | 167 | 84 | 71 | 129 | 165 | 174 | 100 |
| 40 | 102 | 85 | 147 | 130 | 177 | 175 | 95 |
| 41 | 21 | 86 | 31 | 131 | 170 | 176 | 90 |
| 42 | 153 | 87 | 87 | 132 | 76 | 177 | 168 |
| 43 | 69 | 88 | 111 | 133 | 77 | 178 | 138 |
| 44 | 34 | 89 | 10 | 134 | 140 | 179 | 130 |

**Table 6:** PAM **constellation** B9 for code rate 9/15

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | -0,7062 | 16 | -0,2985 | 32 | 0,7062 | 48 | 0,2985 |
| 1 | -0,7062 | 17 | -0,2985 | 33 | 0,7062 | 49 | 0,2985 |
| 2 | -0,7524 | 18 | -0,2985 | 34 | 0,7524 | 50 | 0,2985 |
| 3 | -0,7524 | 19 | -0,2985 | 35 | 0,7524 | 51 | 0,2985 |
| 4 | -0,5669 | 20 | -0,4262 | 36 | 0,5669 | 52 | 0,4262 |
| 5 | -0,5669 | 21 | -0,4262 | 37 | 0,5669 | 53 | 0,4262 |
| 6 | -0,5669 | 22 | -0,4262 | 38 | 0,5669 | 54 | 0,4262 |
| 7 | -0,5669 | 23 | -0,4262 | 39 | 0,5669 | 55 | 0,4262 |
| 8 | -1,0017 | 24 | -0,1757 | 40 | 1,0017 | 56 | 0,1757 |
| 9 | -1,0398 | 25 | -0,1757 | 41 | 1,0398 | 57 | 0,1757 |
| 10 | -0,8947 | 26 | -0,1757 | 42 | 0,8947 | 58 | 0,1757 |
| 11 | -0,8885 | 27 | -0,1757 | 43 | 0,8885 | 59 | 0,1757 |
| 12 | -1,2675 | 28 | -0,0592 | 44 | 1,2675 | 60 | 0,0592 |
| 13 | -1,1673 | 29 | -0,0592 | 45 | 1,1673 | 61 | 0,0592 |
| 14 | -1,4286 | 30 | -0,0592 | 46 | 1,4286 | 62 | 0,0592 |
| 15 | -1,6369 | 31 | -0,0592 | 47 | 1,6369 | 63 | 0,0592 |

Tables 7 and 8 disclose the optimized cyclic block permutation and an alternative non-uniform QAM constellation according to the present invention for a code rate of 13/15.

**Table 7: QB permutation for code rate 13/15 and Pam constellation B13**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 42 | 45 | 7 | 90 | 63 | 135 | 130 |
| 1 | 91 | 46 | 101 | 91 | 110 | 136 | 8 |
| 2 | 169 | 47 | 165 | 92 | 159 | 137 | 157 |
| 3 | 68 | 48 | 13 | 93 | 72 | 138 | 120 |
| 4 | 149 | 49 | 48 | 94 | 145 | 139 | 106 |
| 5 | 30 | 50 | 76 | 95 | 81 | 140 | 94 |
| 6 | 69 | 51 | 2 | 96 | 38 | 141 | 22 |
| 7 | 99 | 52 | 122 | 97 | 59 | 142 | 21 |
| 8 | 124 | 53 | 53 | 98 | 144 | 143 | 102 |
| 9 | 97 | 54 | 43 | 99 | 25 | 144 | 125 |
| 10 | 0 | 55 | 15 | 100 | 178 | 145 | 114 |
| 11 | 156 | 56 | 143 | 101 | 18 | 146 | 121 |
| 12 | 54 | 57 | 162 | 102 | 34 | 147 | 128 |
| 13 | 84 | 58 | 52 | 103 | 45 | 148 | 146 |
| 14 | 88 | 59 | 1 | 104 | 132 | 149 | 3 |
| 15 | 86 | 60 | 104 | 105 | 66 | 150 | 50 |
| 16 | 29 | 61 | 126 | 106 | 9 | 151 | 36 |
| 17 | 140 | 62 | 11 | 107 | 23 | 152 | 170 |
| 18 | 118 | 63 | 131 | 108 | 138 | 153 | 112 |
| 19 | 32 | 64 | 111 | 109 | 28 | 154 | 116 |
| 20 | 98 | 65 | 119 | 110 | 134 | 155 | 55 |
| 21 | 35 | 66 | 103 | 111 | 175 | 156 | 47 |
| 22 | 73 | 67 | 177 | 112 | 62 | 157 | 147 |
| 23 | 135 | 68 | 93 | 113 | 137 | 158 | 141 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 82 | 69 | 172 | 114 | 75 | 159 | 6 |
| 25 | 17 | 70 | 70 | 115 | 10 | 160 | 108 |
| 26 | 151 | 71 | 166 | 116 | 74 | 161 | 61 |
| 27 | 20 | 72 | 12 | 117 | 174 | 162 | 67 |
| 28 | 80 | 73 | 57 | 118 | 85 | 163 | 123 |
| 29 | 49 | 74 | 167 | 119 | 117 | 164 | 44 |
| 30 | 152 | 75 | 39 | 120 | 164 | 165 | 127 |
| 31 | 136 | 76 | 163 | 121 | 19 | 166 | 150 |
| 32 | 139 | 77 | 154 | 122 | 153 | 167 | 87 |
| 33 | 109 | 78 | 171 | 123 | 78 | 168 | 161 |
| 34 | 129 | 79 | 133 | 124 | 105 | 169 | 51 |
| 35 | 142 | 80 | 64 | 125 | 173 | 170 | 90 |
| 36 | 26 | 81 | 65 | 126 | 24 | 171 | 16 |
| 37 | 77 | 82 | 92 | 127 | 158 | 172 | 113 |
| 38 | 148 | 83 | 176 | 128 | 95 | 173 | 14 |
| 39 | 5 | 84 | 168 | 129 | 179 | 174 | 115 |
| 40 | 79 | 85 | 27 | 130 | 60 | 175 | 107 |
| 41 | 56 | 86 | 37 | 131 | 100 | 176 | 71 |
| 42 | 4 | 87 | 31 | 132 | 40 | 177 | 160 |
| 43 | 89 | 88 | 96 | 133 | 58 | 178 | 41 |
| 44 | 155 | 89 | 83 | 134 | 46 | 179 | 33 |

**Table 8:** **PAM constellation** B13 for code rate 13/15

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | -0,7647 | 16 | -0,3361 | 32 | 0,7647 | 48 | 0,3361 |
| 1 | -0,7188 | 17 | -0,369 | 33 | 0,7188 | 49 | 0,369 |
| 2 | -0,8127 | 18 | -0,3009 | 34 | 0,8127 | 50 | 0,3009 |
| 3 | -0,863 | 19 | -0,2695 | 35 | 0,863 | 51 | 0,2695 |
| 4 | -0,6325 | 20 | -0,4397 | 36 | 0,6325 | 52 | 0,4397 |
| 5 | -0,6747 | 21 | -0,405 | 37 | 0,6747 | 53 | 0,405 |
| 6 | -0,5916 | 22 | -0,4768 | 38 | 0,5916 | 54 | 0,4768 |
| 7 | -0,5523 | 23 | -0,5136 | 39 | 0,5523 | 55 | 0,5136 |
| 8 | -1,0304 | 24 | -0,1702 | 40 | 1,0304 | 56 | 0,1702 |
| 9 | -1,0927 | 25 | -0,1415 | 41 | 1,0927 | 57 | 0,1415 |
| 10 | -0,9716 | 26 | -0,2048 | 42 | 0,9716 | 58 | 0,2048 |
| 11 | -0,9159 | 27 | -0,2347 | 43 | 0,9159 | 59 | 0,2347 |
| 12 | -1,2304 | 28 | -0,0791 | 44 | 1,2304 | 60 | 0,0791 |
| 13 | -1,159 | 29 | -0,107 | 45 | 1,159 | 61 | 0,107 |
| 14 | -1,3082 | 30 | -0,0446 | 46 | 1,3082 | 62 | 0,0446 |
| 15 | -1,3962 | 31 | -0,0173 | 47 | 1,3962 | 63 | 0,0173 |

Mapping on cells is achieved by computing s = p(x') + j·p(x"), wherein non-uniform PAM coordinates p(x) are taken from Table 2 or 6 for code rate 9/15 and from Table 4 or 8 for code rate 13/15. The address labels for the real part, x', are computed based on the even numbered bits from the section interleaver output $b_0$, $b_2$, $b_4$, $b_8$, $b_{10}$:

$$x' = \sum_{i=0}^{5} 2^{5-i}\, b_{2i} \, ,$$

whereas address labels for the imaginary part, x", are computed based on the odd numbered bits $b_1$, $b_3$, $b_5$, $b_7$, $b_9$, $b_{11}$:

$$x" = \sum_{i=0}^{5} 2^{5-i}\, b_{2i+1} \, .$$

The above described cyclic-block permutations and constellations are relevant for both the transmitter side and the receiver side in a digital communication system. Each of the above permutations uniquely defines also its inverse permutation, either one of which is used at the transmitter side for bit interleaving or at the receiver side for bit de-interleaving. Further, the above definitions of 2D non-uniform constellations form the basis for mapping constellation words, i.e., bits of the codeword, onto complex cells used for transmission, as well for demapping the complex cells received at the other end of the communication channel.

The above described cyclic-block permutations and constellations have been optimized for two specific LDPC codes with a code rate of 9/15 and 13/15, respectively. Each LDPC code is defined by way of the following algorithm:

1. The code bits are denoted by $c_0$, $c_1$,..., $c_{N-1}$, where the first K bits equal information bits, i.e., $c_k = i_k$ for $0 \le k < K$. The parity bits $p_k = c_{k+K}$ are computed as follows.

2. Initialize $p_k = 0$ for $0 \le k < N - K$, where N = 64800, and K = N*code rate

3. For $0 \leq k < K$, set $i = \lfloor k/360 \rfloor$, with $\lfloor x \rfloor$ being the largest integer not greater than x, and $l = k \mod 360$. Now accumulate $i_k$ to $p_{q(i,j,l)}$ for all j:

$$p_{q(i,0,l)} = p_{q(i,0,l)} + i_k, \quad p_{q(i,1,l)} = p_{q(i,1,l)} + i_k, \quad p_{q(i,2,l)} = p_{q(i,2,l)} + i_k,$$

$$p_{q(i,w(i)-1,l)} = p_{q(i,w(i)-1,l)} + i_k,$$

where w(i) is the number of elements in the i-th row in the indices list in Table 9 and Table 10.

4. For all $0 < k < N-K$, $p_k = (p_k + p_{k-1}) \mod 2$.

5. By the above steps, all code bits $c_0, c_1, ..., c_{N-1}$ are obtained. A parity interleaver is applied to the last N - K codebits:

$$u_i = c_i, \quad 0 \leq i < K$$

$$u_{K+360t+s} = c_{K+Rs+t}, \quad 0 \leq s < 360, \quad 0 \leq t < R.$$

The role of the parity interleaver is to convert the staircase structure of the parity-part of the LDPC parity-check matrix into a quasi-cyclic structure similar to the information-part of the matrix. The parity interleaved code bits $u_0, u_1, ..., u_{N-1}$ are then passed to the parallel bit interleaver.

The parameters q(i,j,0) denote the j-th entry in the i-th row in the indices listed in Table 9 and Table 10 herebelow, and $q(i,j,l) = q(i,j,0) + R \cdot l \ (\mod (N - K))$ for $0 < l < 360$. All accumulations are realized by additions in GF(2). R equals 72 for code rate 9/15, and 24 for code rate 13/15.

**Table 9: LDPC Code description for code rate 9/15**

| |
|---|
| 113 1557 3316 5680 6241 10407 13404 13947 14040 14353 15522 15698 16079 17363 19374 19543 20530 22833 24339 |
| 271 1361 6236 7006 7307 7333 12768 15441 15568 17923 18341 20321 21502 22023 23938 25351 25590 25876 25910 |
| 73 605 872 4008 6279 7653 10346 10799 12482 12935 13604 15909 16526 19782 20506 22804 23629 24859 25600 |
| 1445 1690 4304 4851 8919 9176 9252 13783 16076 16675 17274 18806 18882 20819 21958 22451 23869 23999 24177 |
| 1290 2337 5661 6371 8996 10102 10941 11360 12242 14918 16808 20571 23374 24046 25045 25060 25662 25783 25913 |
| 28 42 1926 3421 3503 8558 9453 10168 15820 17473 19571 19685 22790 23336 23367 23890 24061 25657 25680 |
| 0 1709 4041 4932 5968 7123 8430 9564 10596 11026 14761 19484 20762 20858 23803 24016 24795 25853 25863 |
| 29 1625 6500 6609 16831 18517 18568 18738 19387 20159 20544 21603 21941 24137 24269 24416 24803 25154 25395 |
| 55 66 871 3700 11426 13221 15001 16367 17601 18380 22796 23488 23938 25476 25635 25678 25807 25857 25872 |
| 1 19 5958 8548 8860 11489 16845 18450 18469 19496 20190 23173 25262 25566 25668 25679 25858 25888 25915 |
| 7520 7690 8855 9183 14654 16695 17121 17854 18083 18428 19633 20470 20736 21720 22335 23273 25083 25293 25403 |
| 48 58 410 1299 3786 10668 18523 18963 20864 22106 22308 23033 23107 23128 23990 24286 24409 24595 25802 |
| 12 51 3894 6539 8276 10885 11644 12777 13427 14039 15954 17078 19053 20537 22863 24521 25087 25463 25838 |
| 3509 8748 9581 11509 15884 16230 17583 19264 20900 21001 21310 22547 22756 22959 24768 24814 25594 25626 25880 |

(continued)

| |
|---|
| 21 29 69 1448 2386 4601 6626 6667 10242 1314113852 14137 18640 19951 22449 23454 24431 25512 25814 |
| 18 53 7890 9934 10063 16728 19040 19809 20825 21522 21800 23582 24556 25031 25547 25562 25733 25789 25906 |
| 4096 4582 5766 5894 6517 10027 12182 13247 15207 17041 18958 20133 20503 22228 24332 24613 25689 25855 25883 |
| 0 25 819 5539 7076 7536 7695 9532 13668 15051 17683 19665 20253 21996 24136 24890 25758 25784 25807 |
| 34 40 44 4215 6076 7427 7965 8777 11017 15593 19542 22202 22973 23397 23423 24418 24873 25107 25644 |
| 1595 6216 22850 25439 |
| 1562 15172 19517 22362 |
| 7508 12879 24324 24496 |
| 6298 15819 16757 18721 |
| 11173 15175 19966 21195 |
| 59 13505 16941 23793 |
| 2267 4830 12023 20587 |
| 8827 9278 13072 16664 |
| 14419 17463 23398 25348 |
| 6112 16534 20423 22698 |
| 493 8914 21103 24799 |
| 6896 12761 13206 25873 |
| 2 1380 12322 21701 |
| 11600 21306 25753 25790 |
| 8421 13076 14271 15401 |
| 9630 14112 19017 20955 |
| 212 13932 21781 25824 |
| 5961 9110 16654 19636 |
| 58 5434 9936 12770 |
| 6575 11433 19798 |
| 2731 7338 20926 |
| 14253 18463 25404 |
| 21791 24805 25869 |
| 2 11646 15850 |
| 6075 8586 23819 |
| 18435 22093 24852 |
| 2103 2368 11704 |
| 10925 17402 18232 |
| 9062 25061 25674 |
| 18497 20853 23404 |
| 18606 19364 19551 |
| 7 1022 25543 |

| |
|---|
| 6744 15481 25868 |
| 9081 17305 25164 |
| 8 2370125883 |
| 9680 19955 22848 |
| 56 4564 19121 |
| 5595 15086 25892 |
| 3174 17127 23183 |
| 19397 19817 20275 |
| 12561 24571 25825 |
| 7111 9889 25865 |
| 19104 20189 21851 |
| 549 9686 25548 |
| 6586 20325 25906 |
| 3224 20710 21637 |
| 641 15215 25754 |
| 13484 23729 25818 |
| 2043 7493 24246 |
| 16860 25230 25768 |
| 22047 24200 24902 |
| 9391 18040 19499 |
| 7855 24336 25069 |
| 23834 25570 25852 |
| 1977 8800 25756 |
| 6671 21772 25859 |
| 3279 6710 24444 |
| 24099 25117 25820 |
| 5553 12306 25915 |
| 48 11107 23907 |
| 10832 11974 25773 |
| 2223 17905 25484 |
| 16782 17135 20446 |
| 475 2861 3457 |
| 16218 22449 24362 |
| 11716 22200 25897 |
| 8315 15009 22633 |
| 13 20480 25852 |
| 12352 18658 25687 |
| 3681 14794 23703 |
| 30 24531 25846 |

(continued)

| 4103 22077 24107 |
| 23837 25622 25812 |
| 3627 13387 25839 |
| 908 5367 19388 |
| 0 6894 25795 |
| 20322 23546 25181 |
| 8178 25260 25437 |
| 2449 13244 22565 |
| 31 18928 22741 |
| 1312 5134 14838 |
| 6085 13937 24220 |
| 66 14633 25670 |
| 47 22512 25472 |
| 8867 24704 25279 |
| 6742 21623 22745 |
| 147 9948 24178 |
| 8522 24261 24307 |
| 19202 22406 24609 |

**Table 10: LDPC Code description for code rate 13/15**

| | |
|---|---|
| 42 2307 2598 2650 4028 4434 5781 5881 6016 6323 6681 6698 8125 | 1704 2480 4181 |
| 2932 4928 5248 5256 5983 6773 6828 7789 8426 8494 8534 8539 8583 | 7338 7929 7990 |
| 899 3295 3833 5399 6820 7400 7753 7890 8109 8451 8529 8564 8602 | 2615 3905 7981 |
| 21 3060 4720 5429 5636 5927 6966 8110 8170 8247 8355 8365 8616 | 1298 4548 8296 |
| 20 1745 2838 3799 4380 4418 4646 5059 7343 8161 8302 8456 8631 | 8262 8319 8630 |
| 9 6274 6725 6792 7195 7333 8027 8186 8209 8273 8442 8548 8632 | 892 1893 8028 |
| 494 1365 2405 3799 5188 5291 7644 7926 8139 8458 8504 8594 8625 | 5694 7237 8595 |
| 192 574 1179 4387 4695 5089 5831 7673 7789 8298 8301 8612 8632 | 1487 5012 5810 |
| 11 20 1406 6111 6176 6256 6708 6834 7828 8232 8457 8495 8602 | 4335 8593 8624 |
| 6 2654 3554 4483 4966 5866 6795 8069 8249 8301 8497 8509 8623 | 3509 4531 5273 |
| 21 1144 2355 3124 6773 6805 6887 7742 7994 8358 8374 8580 8611 | 10 22 830 |
| 335 4473 4883 5528 6096 7543 7586 7921 8197 8319 8394 8489 8636 | 4161 5208 6280 |
| 2919 4331 4419 4735 6366 6393 6844 7193 8165 8205 8544 8586 8617 | 275 7063 8634 |
| 12 19 742 930 3009 4330 6213 6224 7292 7430 7792 7922 8137 | 4 2725 3113 |
| 710 1439 1588 2434 3516 5239 6248 6827 8230 8448 8515 8581 8619 | 2279 7403 8174 |
| 200 1075 1868 5581 7349 7642 7698 8037 8201 8210 8320 8391 8526 | 1637 3328 3930 |
| 3 2501 4252 5256 5292 5567 6136 6321 6430 6486 7571 8521 8636 | 2810 4939 5624 |
| 3062 4599 5885 6529 6616 7314 7319 7567 8024 8153 8302 8372 8598 | 3 1234 7687 |

(continued)

| | |
|---|---|
| 105 381 1574 4351 5452 5603 5943 7467 7788 7933 8362 8513 8587 | 2799 7740 8616 |
| 787 1857 3386 3659 6550 7131 7965 8015 8040 8312 8484 8525 8537 | 22 7701 8636 |
| 15 1118 4226 5197 5575 5761 6762 7038 8260 8338 8444 8512 8568 | 4302 7857 7993 |
| 36 5216 5368 5616 6029 6591 8038 8067 8299 8351 8565 8578 8585 | 7477 7794 8592 |
| 1 23 4300 4530 5426 5532 5817 6967 7124 7979 8022 8270 8437 | 9 6111 8591 |
| 629 2133 4828 5475 5875 5890 7194 8042 8345 8385 8518 8598 8612 | 5 8606 8628 |
| 11 1065 3782 4237 4993 7104 7863 7904 8104 8228 8321 8383 8565 | 347 3497 4033 |
| 2131 2274 3168 3215 3220 5597 6347 7812 8238 8354 8527 8557 8614 | 1747 2613 8636 |
| 5600 6591 7491 7696 | 1827 5600 7042 |
| 1766 8281 8626 | 580 1822 6842 |
| 1725 2280 5120 | 232 7134 7783 |
| 1650 3445 7652 | 1629 5000 7231 |
| 4312 6911 8626 | 951 2806 4947 |
| 15 1013 5892 | 571 3474 8577 |
| 2263 2546 2979 | 2437 2496 7945 |
| 1545 5873 7406 | 23 5873 8162 |
| 67 726 3697 | 12 1168 7686 |
| 2860 6443 8542 | 8315 8540 8596 |
| 17 911 2820 | 1766 2506 4733 |
| 1561 4580 6052 | 929 1516 3338 |
| 79 5269 7134 | 21 1216 6555 |
| 22 2410 2424 | 782 1452 8617 |
| 3501 5642 8627 | 8 6083 6087 |
| 808 6950 8571 | 667 3240 4583 |
| 4099 6389 7482 | 4030 4661 5790 |
| 4023 5000 7833 | 559 7122 8553 |
| 547657657917 | 3202 4388 4909 |
| 1008 3194 7207 | 2 533 3673 8594 |
| 20 495 5411 | 1991 3954 6206 |
| 1703 8388 8635 | 6835 7900 7980 |
| 6 4395 4921 | 189 5722 8573 |
| 200 2053 8206 | 2680 4928 4998 |
| 1089 5126 5562 | 243 2579 7735 |
| 10 4193 7720 | 4281 8132 8566 |
| 1967 2151 4608 | 7656 7671 8609 |
| 22 738 3513 | 1116 2291 4166 |
| 3385 5066 8152 | 21 388 8021 |
| 440 1118 8537 | 6 1123 8369 |
| 3429 6058 7716 | 311 4918 8511 |

(continued)

| | |
|---|---|
| 5213 7519 8382 | 0 3248 6290 |
| 5564 8365 8620 | 13 6762 7172 |
| 43 3219 8603 | 4209 5632 7563 |
| 4 5409 5815 | 49 127 8074 |
| 5 6376 7654 | 581 1735 4075 |
| 4091 5724 5953 | 0 2235 5470 |
| 5348 6754 8613 | 2178 5820 6179 |
| 1634 6398 6632 | 16 3575 6054 |
| 72 2058 8605 | 1095 4564 6458 |
| 3497 5811 7579 | 9 1581 5953 |
| 3846 6743 8559 | 2537 6469 8552 |
| 15 5933 8629 | 14 3874 4844 |
| 2133 5859 7068 | 0 3269 3551 |
| 4 151 4617 8566 | 2114 7372 7926 |
| 2960 8270 8410 | 1875 2388 4057 |
| 2059 3617 8210 | 3232 4042 6663 |
| 544 1441 6895 | 9 401 583 |
| 4043 7482 8592 | 13 4100 6584 |
| 294 2180 8524 | 2 299 4190 4410 |
| 3058 8227 8373 | 21 3670 4979 |
| 364 5756 8617 | |
| 5383 8555 8619 | |

Although the present invention has been described by referring to specific embodiments illustrated in the enclosed figures, in particular by providing exemplary values for the key parameters N, M, and Q, the present invention is not restricted to any specific combination of such parameters. In fact, the present invention can be applied to any practically relevant combination of values (positive integers) for these parameters, such as those mentioned in the background section in the context of the DVB-T2 standard or defined by similar standards.

Further, the present invention is not restricted to a particular form for implementing the disclosed methods and devices, both in software or in hardware. Specifically, the invention may be implemented in form of a computer-readable medium having embodied thereon computer-executable instructions that are adapted for allowing a computer, a microprocessor, a microcontroller, and the like, to perform all steps of a method according to the embodiments of the present invention. The invention may also be implemented in form of an application-specific integrated circuit (ASIC) or in form of a field programmable gate array (FPGA).

Summarizing, the present invention relates to digital communication systems based on quasi-cyclic low-density parity-check (QC-LDPC) codes and high-order constellations. The invention provides specific permutations for interleaving bits of an LDPC codeword and specific non-uniform constellations for transmitting the interleaved codeword. The permutations and the non-uniform constellations have been jointly optimized for code rates of 9/15 and 13/15.

**Claims**

1. A method for communicating data in a digital communication system employing a quasi-cyclic low-density parity-check code, the method comprising:

an interleaving step for applying a cyclic block permutation to a codeword of the quasi-cyclic low-density parity-check code, the codeword consisting of a sequence of N cyclic blocks, each cyclic block consisting of Q bits, N and Q being positive integers, the cyclic block permutation being configured for permuting the sequence of cyclic blocks within the codeword; and

a constellation mapping or de-mapping step for mapping bits of the permuted codeword to constellation points of a non-uniform constellation, or vice versa,

the non-uniform constellation and the cyclic-block permutation being selected on the basis of a code rate of the employed quasi-cyclic low-density parity-check code.

**2.** A method according to claim 1, wherein the quasi-cyclic low-density parity-check code has a code rate of 9/15 and the selected non-uniform constellation is a non-uniform 4096-QAM constellation having real and complex coordinates given by non-uniform 64-PAM according to the following table:

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,6273 | 16 | 0,0573 | 32 | -1,6273 | 48 | -0,0573 |
| 1 | 1,4346 | 17 | 0,0574 | 33 | -1,4346 | 49 | -0,0574 |
| 2 | 1,1703 | 18 | 0,0574 | 34 | -1,1703 | 50 | -0,0574 |
| 3 | 1,283 | 19 | 0,0575 | 35 | -1,283 | 51 | -0,0575 |
| 4 | 0,8854 | 20 | 0,1728 | 36 | -0,8854 | 52 | -0,1728 |
| 5 | 0,8979 | 21 | 0,1726 | 37 | -0,8979 | 53 | -0,1726 |
| 6 | 1,0517 | 22 | 0,1724 | 38 | -1,0517 | 54 | -0,1724 |
| 7 | 1,0063 | 23 | 0,1722 | 39 | -1,0063 | 55 | -0,1722 |
| 8 | 0,5401 | 24 | 0,4247 | 40 | -0,5401 | 56 | -0,4247 |
| 9 | 0,5402 | 25 | 0,4244 | 41 | -0,5402 | 57 | -0,4244 |
| 10 | 0,5772 | 26 | 0,4122 | 42 | -0,5772 | 58 | -0,4122 |
| 11 | 0,5777 | 27 | 0,4118 | 43 | -0,5777 | 59 | -0,4118 |
| 12 | 0,7733 | 28 | 0,2904 | 44 | -0,7733 | 60 | -0,2904 |
| 13 | 0,7706 | 29 | 0,2905 | 45 | -0,7706 | 61 | -0,2905 |
| 14 | 0,6908 | 30 | 0,2937 | 46 | -0,6908 | 62 | -0,2937 |
| 15 | 0,6902 | 31 | 0,2935 | 47 | -0,6902 | 63 | -0,2935 |

**3.** A method according to claim 1 or 2, wherein the quasi-cyclic low-density parity-check code has a code rate of 9/15 and the selected cyclic-block permutation or its inverse is defined according to the following table:

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 143 | 45 | 80 | 90 | 163 | 135 | 16 |
| 1 | 34 | 46 | 39 | 91 | 109 | 136 | 41 |
| 2 | 146 | 47 | 82 | 92 | 158 | 137 | 176 |
| 3 | 131 | 48 | 21 | 93 | 6 | 138 | 141 |
| 4 | 47 | 49 | 0 | 94 | 175 | 139 | 89 |
| 5 | 70 | 50 | 66 | 95 | 73 | 140 | 139 |
| 6 | 48 | 51 | 67 | 96 | 4 | 141 | 111 |
| 7 | 75 | 52 | 38 | 97 | 11 | 142 | 127 |
| 8 | 114 | 53 | 60 | 98 | 27 | 143 | 155 |
| 9 | 103 | 54 | 2 | 99 | 62 | 144 | 117 |
| 10 | 164 | 55 | 125 | 100 | 33 | 145 | 74 |
| 11 | 168 | 56 | 144 | 101 | 157 | 146 | 9 |
| 12 | 40 | 57 | 55 | 102 | 161 | 147 | 84 |
| 13 | 100 | 58 | 86 | 103 | 58 | 148 | 50 |
| 14 | 149 | 59 | 126 | 104 | 45 | 149 | 162 |
| 15 | 128 | 60 | 99 | 105 | 43 | 150 | 87 |
| 16 | 151 | 61 | 63 | 106 | 140 | 151 | 133 |
| 17 | 76 | 62 | 178 | 107 | 110 | 152 | 36 |
| 18 | 115 | 63 | 26 | 108 | 24 | 153 | 96 |
| 19 | 77 | 64 | 17 | 109 | 145 | 154 | 12 |
| 20 | 5 | 65 | 83 | 110 | 118 | 155 | 31 |
| 21 | 90 | 66 | 97 | 111 | 122 | 156 | 57 |
| 22 | 105 | 67 | 167 | 112 | 1 | 157 | 92 |
| 23 | 171 | 68 | 142 | 113 | 120 | 158 | 147 |
| 24 | 172 | 69 | 121 | 114 | 134 | 159 | 104 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 25 | 71 | 70 | 165 | 115 | 108 | 160 | 42 |
| 26 | 53 | 71 | 95 | 116 | 14 | 161 | 78 |
| 27 | 160 | 72 | 170 | 117 | 61 | 162 | 154 |
| 28 | 106 | 73 | 173 | 118 | 112 | 163 | 7 |
| 29 | 30 | 74 | 22 | 119 | 153 | 164 | 101 |
| 30 | 8 | 75 | 159 | 120 | 10 | 165 | 129 |
| 31 | 56 | 76 | 3 | 121 | 148 | 166 | 135 |
| 32 | 136 | 77 | 137 | 122 | 124 | 167 | 138 |
| 33 | 166 | 78 | 52 | 123 | 88 | 168 | 46 |
| 34 | 81 | 79 | 116 | 124 | 98 | 169 | 44 |
| 35 | 20 | 80 | 152 | 125 | 179 | 170 | 54 |
| 36 | 23 | 81 | 49 | 126 | 18 | 171 | 35 |
| 37 | 32 | 82 | 72 | 127 | 37 | 172 | 102 |
| 38 | 174 | 83 | 107 | 128 | 169 | 173 | 68 |
| 39 | 123 | 84 | 65 | 129 | 29 | 174 | 91 |
| 40 | 25 | 85 | 51 | 130 | 13 | 175 | 19 |
| 41 | 94 | 86 | 93 | 131 | 113 | 176 | 177 |
| 42 | 156 | 87 | 15 | 132 | 132 | 177 | 28 |
| 43 | 59 | 88 | 79 | 133 | 85 | 178 | 150 |
| 44 | 130 | 89 | 64 | 134 | 69 | 179 | 119 |

4. A method according to claim 1, wherein the quasi-cyclic low-density parity-check code has a code rate of 13/15 and the selected non-uniform constellation is a non-uniform 4096-QAM constellation having real and complex coordinates given by non-uniform 64-PAM according to the following table:

| Address Label x (integer, MSB first) | PAM spots $p(x)$ | Address Label x (integer, MSB first) | PAM spots $p(x)$ | Address Label x (integer, MSB first) | PAM spots $p(x)$ | Address Label x (integer, MSB first) | PAM spots $p(x)$ |
|---|---|---|---|---|---|---|---|
| 0 | 1,3691 | 16 | 0,0166 | 32 | -1,3691 | 48 | -0,0166 |
| 1 | 1,2875 | 17 | 0,0487 | 33 | -1,2875 | 49 | -0,0487 |
| 2 | 1,1481 | 18 | 0,114 | 34 | -1,1481 | 50 | -0,114 |
| 3 | 1,2149 | 19 | 0,0819 | 35 | -1,2149 | 51 | -0,0819 |
| 4 | 0,9184 | 20 | 0,2462 | 36 | -0,9184 | 52 | -0,2462 |
| 5 | 0,9713 | 21 | 0,2133 | 37 | -0,9713 | 53 | -0,2133 |
| 6 | 1,0859 | 22 | 0,1473 | 38 | -1,0859 | 54 | -0,1473 |
| 7 | 1,0273 | 23 | 0,1796 | 39 | -1,0273 | 55 | -0,1796 |
| 8 | 0,5657 | 24 | 0,5275 | 40 | -0,5657 | 56 | -0,5275 |
| 9 | 0,6047 | 25 | 0,4904 | 41 | -0,6047 | 57 | -0,4904 |
| 10 | 0,6861 | 26 | 0,4183 | 42 | -0,6861 | 58 | -0,4183 |
| 11 | 0,6449 | 27 | 0,4537 | 43 | -0,6449 | 59 | -0,4537 |
| 12 | 0,8677 | 28 | 0,2803 | 44 | -0,8677 | 60 | -0,2803 |
| 13 | 0,8194 | 29 | 0,3138 | 45 | -0,8194 | 61 | -0,3138 |
| 14 | 0,7288 | 30 | 0,3829 | 46 | -0,7288 | 62 | -0,3829 |
| 15 | 0,7731 | 31 | 0,3484 | 47 | -0,7731 | 63 | -0,3484 |

5. A method according to claim 1 or 4, wherein the quasi-cyclic low-density parity-check code has a code rate of 13/15 and the selected cyclic-block permutation or its inverse is defined according to the following table:

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 97 | 45 | 142 | 90 | 67 | 135 | 141 |
| 1 | 133 | 46 | 34 | 91 | 131 | 136 | 173 |
| 2 | 55 | 47 | 124 | 92 | 53 | 137 | 26 |
| 3 | 104 | 48 | 90 | 93 | 121 | 138 | 145 |
| 4 | 56 | 49 | 49 | 94 | 162 | 139 | 155 |
| 5 | 21 | 50 | 77 | 95 | 58 | 140 | 93 |
| 6 | 36 | 51 | 157 | 96 | 89 | 141 | 100 |
| 7 | 126 | 52 | 127 | 97 | 27 | 142 | 113 |
| 8 | 122 | 53 | 123 | 98 | 118 | 143 | 40 |
| 9 | 132 | 54 | 11 | 99 | 83 | 144 | 65 |
| 10 | 68 | 55 | 61 | 100 | 153 | 145 | 99 |
| 11 | 0 | 56 | 115 | 101 | 12 | 146 | 31 |
| 12 | 96 | 57 | 24 | 102 | 152 | 147 | 63 |
| 13 | 60 | 58 | 3 | 103 | 23 | 148 | 80 |
| 14 | 71 | 59 | 166 | 104 | 109 | 149 | 176 |
| 15 | 119 | 60 | 111 | 105 | 79 | 150 | 129 |
| 16 | 85 | 61 | 170 | 106 | 14 | 151 | 64 |
| 17 | 147 | 62 | 112 | 107 | 161 | 152 | 76 |
| 18 | 50 | 63 | 44 | 108 | 19 | 153 | 8 |
| 19 | 150 | 64 | 134 | 109 | 47 | 154 | 57 |
| 20 | 140 | 65 | 38 | 110 | 130 | 155 | 75 |
| 21 | 171 | 66 | 6 | 111 | 87 | 156 | 156 |
| 22 | 116 | 67 | 20 | 112 | 106 | 157 | 28 |
| 23 | 174 | 68 | 17 | 113 | 105 | 158 | 32 |
| 24 | 33 | 69 | 149 | 114 | 172 | 159 | 41 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 25 | 165 | 70 | 151 | 115 | 81 | 160 | 92 |
| 26 | 98 | 71 | 37 | 116 | 179 | 161 | 69 |
| 27 | 52 | 72 | 43 | 117 | 35 | 162 | 103 |
| 28 | 16 | 73 | 9 | 118 | 128 | 163 | 72 |
| 29 | 102 | 74 | 169 | 119 | 108 | 164 | 22 |
| 30 | 10 | 75 | 110 | 120 | 7 | 165 | 138 |
| 31 | 2 | 76 | 137 | 121 | 4 | 166 | 148 |
| 32 | 159 | 77 | 114 | 122 | 146 | 167 | 160 |
| 33 | 154 | 78 | 74 | 123 | 168 | 168 | 120 |
| 34 | 101 | 79 | 45 | 124 | 13 | 169 | 136 |
| 35 | 59 | 80 | 143 | 125 | 62 | 170 | 125 |
| 36 | 46 | 81 | 86 | 126 | 94 | 171 | 39 |
| 37 | 5 | 82 | 82 | 127 | 88 | 172 | 135 |
| 38 | 139 | 83 | 42 | 128 | 1 | 173 | 48 |
| 39 | 18 | 84 | 66 | 129 | 177 | 174 | 73 |
| 40 | 117 | 85 | 178 | 130 | 175 | 175 | 158 |
| 41 | 107 | 86 | 78 | 131 | 15 | 176 | 70 |
| 42 | 54 | 87 | 25 | 132 | 91 | 177 | 167 |
| 43 | 30 | 88 | 144 | 133 | 51 | 178 | 164 |
| 44 | 95 | 89 | 163 | 134 | 84 | 179 | 29 |

EP 2 947 837 A1

6. A method according to claim 1, wherein the quasi-cyclic low-density parity-check code has a code rate of 9/15 and the selected non-uniform constellation is a non-uniform 4096-QAM constellation having real and complex coordinates given by non-uniform 64-PAM according to the following table:

| Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ |
|---|---|---|---|---|---|---|---|
| 0 | -0,7062 | 16 | -0,2985 | 32 | 0,7062 | 48 | 0,2985 |
| 1 | -0,7062 | 17 | -0,2985 | 33 | 0,7062 | 49 | 0,2985 |
| 2 | -0,7524 | 18 | -0,2985 | 34 | 0,7524 | 50 | 0,2985 |
| 3 | -0,7524 | 19 | -0,2985 | 35 | 0,7524 | 51 | 0,2985 |
| 4 | -0,5669 | 20 | -0,4262 | 36 | 0,5669 | 52 | 0,4262 |
| 5 | -0,5669 | 21 | -0,4262 | 37 | 0,5669 | 53 | 0,4262 |
| 6 | -0,5669 | 22 | -0,4262 | 38 | 0,5669 | 54 | 0,4262 |
| 7 | -0,5669 | 23 | -0,4262 | 39 | 0,5669 | 55 | 0,4262 |
| 8 | -1,0017 | 24 | -0,1757 | 40 | 1,0017 | 56 | 0,1757 |
| 9 | -1,0398 | 25 | -0,1757 | 41 | 1,0398 | 57 | 0,1757 |
| 10 | -0,8947 | 26 | -0,1757 | 42 | 0,8947 | 58 | 0,1757 |
| 11 | -0,8885 | 27 | -0,1757 | 43 | 0,8885 | 59 | 0,1757 |
| 12 | -1,2675 | 281 | -0,0592 | 44 | 1,2675 | 60 | 0,0592 |
| 13 | -1,1673 | 29 | -0,0592 | 45 | 1,1673 | 61 | 0,0592 |
| 14 | -1,4286 | 30 | -0,0592 | 46 | 1,4286 | 62 | 0,0592 |
| 15 | -1,6369 | 31 | -0,0592 | 47 | 1,6369 | 63 | 0,0592 |

7. A method according to claim 1 or 6, wherein the quasi-cyclic low-density parity-check code has a code rate of 9/15 and the selected cyclic-block permutation or its inverse is defined according to the following table:

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 48 | 45 | 7 | 90 | 89 | 135 | 96 |
| 1 | 161 | 46 | 115 | 91 | 1 | 136 | 55 |
| 2 | 149 | 47 | 26 | 92 | 164 | 137 | 142 |
| 3 | 59 | 48 | 51 | 93 | 70 | 138 | 86 |
| 4 | 146 | 49 | 118 | 94 | 144 | 139 | 117 |
| 5 | 121 | 50 | 171 | 95 | 83 | 140 | 131 |
| 6 | 52 | 51 | 64 | 96 | 5 | 141 | 17 |
| 7 | 123 | 52 | 4 | 97 | 135 | 142 | 61 |
| 8 | 157 | 53 | 105 | 98 | 169 | 143 | 97 |
| 9 | 23 | 54 | 108 | 99 | 20 | 144 | 178 |
| 10 | 91 | 55 | 143 | 100 | 28 | 145 | 45 |
| 11 | 175 | 56 | 94 | 101 | 139 | 146 | 66 |
| 12 | 67 | 57 | 174 | 102 | 173 | 147 | 40 |
| 13 | 58 | 58 | 134 | 103 | 47 | 148 | 75 |
| 14 | 93 | 59 | 14 | 104 | 154 | 149 | 80 |
| 15 | 85 | 60 | 42 | 105 | 38 | 150 | 155 |
| 16 | 133 | 61 | 152 | 106 | 39 | 151 | 72 |
| 17 | 11 | 62 | 50 | 107 | 79 | 152 | 119 |
| 18 | 127 | 63 | 101 | 108 | 49 | 153 | 107 |
| 19 | 44 | 64 | 35 | 109 | 84 | 154 | 82 |
| 20 | 112 | 65 | 65 | 110 | 141 | 155 | 148 |
| 21 | 114 | 66 | 126 | 111 | 120 | 156 | 25 |
| 22 | 74 | 67 | 9 | 112 | 160 | 157 | 128 |
| 23 | 12 | 68 | 125 | 113 | 116 | 158 | 137 |
| 24 | 150 | 69 | 132 | 114 | 16 | 159 | 62 |

(continued)

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 25 | 159 | 70 | 162 | 115 | 32 | 160 | 110 |
| 26 | 30 | 71 | 109 | 116 | 56 | 161 | 145 |
| 27 | 122 | 72 | 2 | 117 | 27 | 162 | 0 |
| 28 | 81 | 73 | 98 | 118 | 60 | 163 | 73 |
| 29 | 151 | 74 | 18 | 119 | 53 | 164 | 78 |
| 30 | 172 | 75 | 136 | 120 | 43 | 165 | 179 |
| 31 | 99 | 76 | 158 | 121 | 156 | 166 | 106 |
| 32 | 22 | 77 | 104 | 122 | 63 | 167 | 68 |
| 33 | 33 | 78 | 163 | 123 | 8 | 168 | 92 |
| 34 | 129 | 79 | 124 | 124 | 36 | 169 | 19 |
| 35 | 15 | 80 | 41 | 125 | 6 | 170 | 46 |
| 36 | 29 | 81 | 13 | 126 | 24 | 171 | 166 |
| 37 | 3 | 82 | 54 | 127 | 88 | 172 | 57 |
| 38 | 103 | 83 | 176 | 128 | 113 | 173 | 37 |
| 39 | 167 | 84 | 71 | 129 | 165 | 174 | 100 |
| 40 | 102 | 85 | 147 | 130 | 177 | 175 | 95 |
| 41 | 21 | 86 | 31 | 131 | 170 | 176 | 90 |
| 42 | 153 | 87 | 87 | 132 | 76 | 177 | 168 |
| 43 | 69 | 88 | 111 | 133 | 77 | 178 | 138 |
| 44 | 34 | 89 | 10 | 134 | 140 | 179 | 130 |

8. A method according to claim 1, wherein the quasi-cyclic low-density parity-check code has a code rate of 13/15 and the selected non-uniform constellation is a non-uniform 4096-QAM constellation having real and complex coordinates given by non-uniform 64-PAM according to the following table:

| Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ |
|---|---|---|---|---|---|---|---|
| 0 | -0,7647 | 16 | -0,3361 | 32 | 0,7647 | 48 | 0,3361 |
| 1 | -0,7188 | 17 | -0,369 | 33 | 0,7188 | 49 | 0,369 |
| 2 | -0,8127 | 18 | -0,3009 | 34 | 0,8127 | 50 | 0,3009 |
| 3 | -0,863 | 19 | -0,2695 | 35 | 0,863 | 51 | 0,2695 |
| 4 | -0,6325 | 20 | -0,4397 | 36 | 0,6325 | 52 | 0,4397 |
| 5 | -0,6747 | 21 | -0,405 | 37 | 0,6747 | 53 | 0,405 |
| 6 | -0,5916 | 22 | -0,4768 | 38 | 0,5916 | 54 | 0,4768 |
| 7 | -0,5523 | 23 | -0,5136 | 39 | 0,5523 | 55 | 0,5136 |
| 8 | -1,0304 | 24 | -0,1702 | 40 | 1,0304 | 56 | 0,1702 |
| 9 | -1,0927 | 25 | -0,1415 | 41 | 1,0927 | 57 | 0,1415 |
| 10 | -0,9716 | 26 | -0,2048 | 42 | 0,9716 | 58 | 0,2048 |
| 11 | -0,9159 | 27 | -0,2347 | 43 | 0,9159 | 59 | 0,2347 |
| 12 | -1,2304 | 28 | -0,0791 | 44 | 1,2304 | 60 | 0,0791 |
| 13 | -1,159 | 29 | -0,107 | 45 | 1,159 | 61 | 0,107 |
| 14 | -1,3082 | 30 | -0,0446 | 46 | 1,3082 | 62 | 0,0446 |
| 15 | -1,3962 | 31 | -0,0173 | 47 | 1,3962 | 63 | 0,0173 |

9. A method according to claim 1 or 8, wherein the quasi-cyclic low-density parity-check code has a code rate of 13/15 and the selected cyclic-block permutation or its inverse is defined according to the following table:

| j-th block of Group-wise Interleaver output | π(j)-th block of Group-wise Interleaver input | block of Group-wise Interleaver output | π(j)-th block of Group-wise Interleaver input | j-th block of Group-wise Interleaver output | π(j)-th block of Group-wise Interleaver input | block Group-wise Interleaver output | π(j)-th block of Group-wise Interleaver input |
|---|---|---|---|---|---|---|---|
| 0 | 42 | 45 | 7 | 90 | 63 | 135 | 130 |
| 1 | 91 | 46 | 101 | 91 | 110 | 136 | 8 |
| 2 | 169 | 47 | 165 | 92 | 159 | 137 | 157 |
| 3 | 68 | 48 | 13 | 93 | 72 | 138 | 120 |
| 4 | 149 | 49 | 48 | 94 | 145 | 139 | 106 |
| 5 | 30 | 50 | 76 | 95 | 81 | 140 | 94 |
| 6 | 69 | 51 | 2 | 96 | 38 | 141 | 22 |
| 7 | 99 | 52 | 122 | 97 | 59 | 142 | 21 |
| 8 | 124 | 53 | 53 | 98 | 144 | 143 | 102 |
| 9 | 97 | 54 | 43 | 99 | 25 | 144 | 125 |
| 10 | 0 | 55 | 15 | 100 | 178 | 145 | 114 |
| 11 | 156 | 56 | 143 | 101 | 18 | 146 | 121 |
| 12 | 54 | 57 | 162 | 102 | 34 | 147 | 128 |
| 13 | 84 | 58 | 52 | 103 | 45 | 148 | 146 |
| 14 | 88 | 59 | 1 | 104 | 132 | 149 | 3 |
| 15 | 86 | 60 | 104 | 105 | 66 | 150 | 50 |
| 16 | 29 | 61 | 126 | 106 | 9 | 151 | 36 |
| 17 | 140 | 62 | 11 | 107 | 23 | 152 | 170 |
| 18 | 118 | 63 | 131 | 108 | 138 | 153 | 112 |
| 19 | 32 | 64 | 111 | 109 | 28 | 154 | 116 |
| 20 | 98 | 65 | 119 | 110 | 134 | 155 | 55 |
| 21 | 35 | 66 | 103 | 111 | 175 | 156 | 47 |
| 22 | 73 | 67 | 177 | 112 | 62 | 157 | 147 |
| 23 | 135 | 68 | 93 | 113 | 137 | 158 | 141 |

36

(continued)

| j-th block of Group-wise Interleaver output | π(j)-th block of Group-wise Interleaver input | block of Group-wise Interleaver output | π(j)-th block of Group-wise Interleaver input | j-th block of Group-wise Interleaver output | π(j)-th block of Group-wise Interleaver input | block Group-wise Interleaver output | π(j)-th block of Group-wise Interleaver input |
|---|---|---|---|---|---|---|---|
| 24 | 82 | 69 | 172 | 114 | 75 | 159 | 6 |
| 25 | 17 | 70 | 70 | 115 | 10 | 160 | 108 |
| 26 | 151 | 71 | 166 | 116 | 74 | 161 | 61 |
| 27 | 20 | 72 | 12 | 117 | 174 | 162 | 67 |
| 28 | 80 | 73 | 57 | 118 | 85 | 163 | 123 |
| 29 | 49 | 74 | 167 | 119 | 117 | 164 | 44 |
| 30 | 152 | 75 | 39 | 120 | 164 | 165 | 127 |
| 31 | 136 | 76 | 163 | 121 | 19 | 166 | 150 |
| 32 | 139 | 77 | 154 | 122 | 153 | 167 | 87 |
| 33 | 109 | 78 | 171 | 123 | 78 | 168 | 161 |
| 34 | 129 | 79 | 133 | 124 | 105 | 169 | 51 |
| 35 | 142 | 80 | 64 | 125 | 173 | 170 | 90 |
| 36 | 26 | 81 | 65 | 126 | 24 | 171 | 16 |
| 37 | 77 | 82 | 92 | 127 | 158 | 172 | 113 |
| 38 | 148 | 83 | 176 | 128 | 95 | 173 | 14 |
| 39 | 5 | 84 | 168 | 129 | 179 | 174 | 115 |
| 40 | 79 | 85 | 27 | 130 | 60 | 175 | 107 |
| 41 | 56 | 86 | 37 | 131 | 100 | 176 | 71 |
| 42 | 4 | 87 | 31 | 132 | 40 | 177 | 160 |
| 43 | 89 | 88 | 96 | 133 | 58 | 178 | 41 |
| 44 | 155 | 89 | 83 | 134 | 46 | 179 | 33 |

**10.** A method according to any of the preceding claims, wherein N=180 and Q=360.

**11.** A method according to any of the preceding claims, further comprising the step of selecting the employed quasi-cyclic low-density parity-check code from a plurality of predefined quasi-cyclic low-density parity-check codes, each of the predefined quasi-cyclic low-density parity-check codes having a distinct code rate.

**12.** A transmitter of a digital communication system, the transmitter being adapted for transmitting data by performing all steps of a method according to any of claims 1 to 11.

**13.** A receiver of a digital communication system, the receiver being adapted for receiving data by performing all steps of a method according to any of claims 1 to 11.

# Fig. 1

| Input Processing | BICM Encoder | OFDM Modulator | Upconverter | RF Amplifier |
|---|---|---|---|---|

110  120  130  140  150  160

Fig. 2

# Fig. 3

QB1 QB2 QB3 QB4 QB5 QB6 QB7 QB8 QB9 QB10 QB11 QB12    QB13 QB14 QB15 QB16 QB17 QB18

Information part      Parity part

# Fig. 4

| QB | Check-node indices for the first bit in each cyclic block QB | | | | |
|----|----|----|----|----|----|
| **1** | **13** | **24** | **27** | **31** | **47** |
| 2 | 4 | 7 | 8 | 22 | 43 |
| 3 | 2 | 15 | 20 | 33 | 35 |
| 4 | 3 | 26 | 29 | | |
| 5 | 12 | 20 | 22 | | |
| 6 | 11 | 22 | 30 | | |
| 7 | 15 | 24 | 38 | | |
| 8 | 13 | 28 | 47 | | |
| 9 | 31 | 42 | 44 | | |
| 10 | 5 | 21 | 39 | | |
| 11 | 16 | 28 | 30 | | |
| 12 | 6 | 19 | 23 | | |

Fig. 5

Information part

# Fig. 6

QB 1  QB 2  QB 3  QB 4  QB 5  QB 6  QB 7  QB 8  QB 9  QB 10  QB 11  QB 12

Information part

Parity part

Fig. 7

QB 1  QB 2  QB 3  QB 4  QB 5  QB 6  QB 7  QB 8  QB 9  QB 10  QB 11  QB 12

Information part                                                    Parity part

# Fig. 8A

### 4-QAM

### 2-PAM

# Fig. 8B

### 16-QAM

### 4-PAM

# Fig. 8C

### 64-QAM

### 8-PAM

# Fig. 9A

**4-QAM**

$b_{1,Re}$ ○───▶ 2-PAM ───▶○ Re

$b_{1,Im}$ ○───▶ 2-PAM ───▶○ Im

# Fig. 9B

**16-QAM**

$b_{1,Re}$ ○───▶
$b_{2,Re}$ ○───▶ 4-PAM ───▶○ Re

$b_{1,Im}$ ○───▶
$b_{2,Im}$ ○───▶ 4-PAM ───▶○ Im

# Fig. 9C

**64-QAM**

$b_{1,Re}$ ○───▶
$b_{2,Re}$ ○───▶ 8-PAM ───▶○ Re
$b_{3,Re}$ ○───▶

$b_{1,Im}$ ○───▶
$b_{2,Im}$ ○───▶ 8-PAM ───▶○ Im
$b_{3,Im}$ ○───▶

# Fig. 10

**Encoded bits $b_3$, $b_2$, $b_1$**

| 100 | 101 | 111 | 110 | 010 | 011 | 001 | 000 |

**Subsets for $b_1$=1 (black), $b_1$=0 (white)**

| $_{10}0$ | $_{10}1$ | $_{11}1$ | $_{11}0$ | $_{01}0$ | $_{01}1$ | $_{00}1$ | $_{00}0$ |

**Subsets for $b_2$=1 (black), $b_2$=0 (white)**

| $_1 0_0$ | $_1 0_1$ | $_1 1_1$ | $_1 1_0$ | $_0 1_0$ | $_0 1_1$ | $_0 0_1$ | $_0 0_0$ |

**Subsets for $b_3$=1 (black), $b_3$=0 (white)**

| $1_{00}$ | $1_{01}$ | $1_{11}$ | $1_{10}$ | $0_{10}$ | $0_{11}$ | $0_{01}$ | $0_{00}$ |

Fig. 11

# Fig. 12A

| | | | | | | | |
|---|---|---|---|---|---|---|---|
| QB1 | $b_{1,Re}$ | $b_{1,Im}$ | | | | | |
| QB2 | $b_{2,Re}$ | $b_{2,Im}$ | | | | | |
| QB3 | $b_{3,Re}$ | $b_{3,Im}$ | | | | | |
| QB4 | $b_{4,Re}$ | $b_{4,Im}$ | | | | | |
| QB5 | $b_{5,Re}$ | $b_{5,Im}$ | | | | | |
| QB6 | $b_{6,Re}$ | $b_{6,Im}$ | | | | | |
| QB7 | | | | | | | |
| QB8 | | | | | | | |
| QB9 | | | | | | | |
| QB10 | | | | | | | |
| QB11 | | | | | | | |
| QB12 | | | | | | | |
| QB13 | | | | | | | |
| QB14 | | | | | | | |
| QB15 | | | | | | | |
| QB16 | | | | | | | |
| QB17 | | | | | | | |
| QB18 | | | | | | | |
| QB19 | | | | | | | |
| QB20 | | | | | | | |
| QB21 | | | | | | | |
| QB22 | | | | | | | |
| QB23 | | | | | | | |
| QB24 | | | | | | | |

Section 1 (QB1–QB6)
Section 2 (QB7–QB12)
Section 3 (QB13–QB18)
Section 4 (QB19–QB24)

# Fig. 12B

122 — Bit interleaver with 6 QBs per section

124-1 — 64 PAM → Re
124-2 — 64 PAM → Im

$b_{1,Re}$, $b_{2,Re}$, ⋮, $b_{6,Re}$, $b_{1,Im}$, $b_{2,Im}$, ⋮, $b_{6,Im}$

$s_1$

# Fig. 12C

write →

read ↓

| | | |
|---|---|---|
| QB1 | $b_{1,Re}$ | $b_{1,Im}$ |
| QB2 | $b_{2,Re}$ | $b_{2,Im}$ |
| QB3 | $b_{3,Re}$ | $b_{3,Im}$ |
| QB4 | $b_{4,Re}$ | $b_{4,Im}$ |
| QB5 | $b_{5,Re}$ | $b_{5,Im}$ |
| QB6 | $b_{6,Re}$ | $b_{6,Im}$ |

$Re\{s_1\}$      $Im\{s_1\}$

# Fig. 13A

# Fig. 13B

# Fig. 13C

# Fig. 14

## EUROPEAN SEARCH REPORT

Application Number

EP 14 16 9537

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DVB ORGANIZATION: "tm4701r4.TM-NGH1181r41_en_303105v010101_1 30603_worm_woc_wbc.docx", DVB, DIGITAL VIDEO BROADCASTING, C/O EBU - 17A ANCIENNE ROUTE - CH-1218 GRAND SACONNEX, GENEVA - SWITZERLAND, 3 June 2013 (2013-06-03), XP017840591, * Section 4.2 Bit-Interleaved Coding and Modulation on pages 34 and 35 * * figure 7 * * figures 98-100 * * Section 15. Bit Interleaver from pages 252 to 255 * * tables 4,6,26 * | 1-13 | INV. H04L27/34 H03M13/11 H03M13/25 H04L1/00 H03M13/27 |
| X | EP 2 690 790 A1 (PANASONIC CORP [JP]) 29 January 2014 (2014-01-29) * paragraphs [0010], [0011] * * paragraphs [0015], [0016] * * paragraphs [0025], [0026] * | 1,10-13 | |
| A | DVB ORGANIZATION: "TM-T0012__Optimization-of-High-order-Non-uniform-QAM-Constellationspdf.pdf", DVB, DIGITAL VIDEO BROADCASTING, C/O EBU - 17A ANCIENNE ROUTE - CH-1218 GRAND SACONNEX, GENEVA - SWITZERLAND, 15 April 2014 (2014-04-15), XP017845158, * pages 4,8,11 * | 1,12,13 | **TECHNICAL FIELDS SEARCHED (IPC)** H04L H03M |

The present search report has been drawn up for all claims

| Place of search | Date of completion of the search | Examiner |
|---|---|---|
| Berlin | 13 October 2014 | Chave, Julien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 16 9537

This annex lists the patent family members relating to the patent documents cited in the above-mentioned European search report.
The members are as contained in the European Patent Office EDP file on
The European Patent Office is in no way liable for these particulars which are merely given for the purpose of information.

13-10-2014

| Patent document cited in search report | Publication date | Patent family member(s) | Publication date |
|---|---|---|---|
| EP 2690790 A1 | 29-01-2014 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 11006087 A